# EUROPEAN PATENT APPLICATION

(11) **EP 3 715 014 A1**
(43) Date of publication of application: **30.09.2020**
(21) Application number: 18878801.2
(22) Date of filing: 19.11.2018
(51) Int. Cl.: B22D 19/00, H01L 23/36, H01L 23/373, H05K 7/20

(54) **COMPOSITE HEAT TRANSFER MEMBER AND METHOD FOR PRODUCING COMPOSITE HEAT TRANSFER MEMBER**

(30) Priority: 20.11.2017 JP 2017222862; 11.07.2018 JP 2018131470
(71) Applicant: Mitsubishi Materials Corporation, Chiyoda-ku, Tokyo 100-8117 (JP)
(72) Inventor: MAEKAWA, Takashi, Yokohama-shi Kanagawa 224-8505 (JP); YAMASHIMA, Susumu, Yokohama-shi Kanagawa 224-8505 (JP)
(74) Representative: Gille Hrabal
(86) International application number: PCT/JP2018/042720
(87) International publication number: WO 2019/098377

(57) **Abstract**

This composite heat transfer member (9) has a carbon plate (1) and a metal cast-molded article (8) covering the surfaces of the plate (1).

## Description

### TECHNICAL FIELD

The present invention relates to a composite heat transfer member and a method for producing a composite heat transfer member.

### BACKGROUND ART

As a material of heat spreaders that transfer heat generated from electronic components or electronic instruments, a copper plate or a graphene laminate is used.

Among these, the graphene laminate has higher thermal conductivity and lower specific gravity compared to the copper plate. Therefore, the graphene laminate is useful as a material of heat spreaders because this material can be compactified and lightened.

On the other hand, the graphene laminate generally has a brittle composition. Therefore, the graphene laminate is likely to be broken due to the stress caused in a case where the laminate is brought into contact with heat sources such as electronic components or electronic instruments or mounted on a mounting portion.

Accordingly, a composite heat transfer member is used which is obtained by covering the graphene laminate with a metal such as copper or aluminum so as to improve the overall strength.

### Citation List

### Patent Literature

[Patent Document 1] Japanese Unexamined Patent Application, First Publication No. 2011-23670
[Patent Document 2] Japanese Unexamined Patent Application, First Publication No. 2012-238733

### DISCLOSURE OF INVENTION

### Technical Problem

However, in the aforementioned composite heat transfer member, high thermal resistance occurs in the bonding interface between the graphene laminate and the metal, and accordingly, the overall thermal conductivity of the composite heat transfer member is reduced.

According to an aspect, an object of the present invention is to provide a composite heat transfer member which can improve thermal conductivity and a method for producing the composite heat transfer member.

### Solution to Problem

According to an aspect of a technique that will be disclosed below, there is provided a composite heat transfer member having a carbon plate and a metal cast-molded article covering a surface of the plate.

According to another aspect of the technique that will be disclosed below, there is provided a method for producing a composite heat transfer member having a step of disposing a carbon plate in a cavity of a casting mold and a step of covering a surface of the plate with a cast-molded article by supplying a molten metal into the cavity so as to form the cast-molded article of the metal.

### Advantageous Effects of Invention

According to the technique that will be disclosed below, the surfaces of the carbon plate are covered with the metal cast-molded article. Therefore, the cast-molded article contacts the surfaces of the plate by surface-to-surface contact. Furthermore, due to the difference in shrinkage between the cast-molded article and the plate at the time of forming the cast-molded article, the cast-molded article is pressed on the surfaces of the plate.

As a result, the cast-molded article is in tight contact with the surfaces of the plate. Therefore, the thermal resistance in the bonding interface between the cast-molded article and the plate is reduced, and the thermal conductivity of the composite heat transfer member can be improved.

### BRIEF DESCRIPTION OF DRAWINGS

FIG. 1A is a cross-sectional view (1) of a composite heat transfer member according to a first embodiment that is in the production process.
FIG. 1B is a cross-sectional view (2) of the composite heat transfer member according to the first embodiment that is in the production process.
FIG. 2 is a cross-sectional view (3) of the composite heat transfer member according to the first embodiment that is in the production process.
FIG. 3 is a perspective view showing the structure of a plate of the first embodiment.
FIG. 4A is a perspective view showing the structure of the composite heat transfer member according to the first embodiment.
FIG. 4B is a cross-sectional view taken along the line I-I in FIG. 4A.
FIG. 5A is a top view showing the positional relationship among a model used for calculating a thermal resistance ratio, a pointlike heat source as a heating portion, and a cooling portion.
FIG. 5B is a lateral view showing the positional relationship among the model used for calculating a thermal resistance ratio, the pointlike heat source as a heating portion, and the cooling portion.
FIG. 6 is a graph showing the results obtained by calculating a thermal resistance ratio of each of the composite heat transfer member of the first embodiment and a heat transfer member of a comparative example.
FIG. 7 is a perspective view showing the structure of a plate of a first modification example of the first embodiment.
FIG. 8A is a perspective view showing the structure of a composite heat transfer member according to the first modification example of the first embodiment.
FIG. 8B is a cross-sectional view taken along the line III-III in FIG. 8A.
FIG. 9A is a perspective view showing the structure of a plate of a second modification example of the first embodiment.
FIG. 9B is a cross-sectional view taken along the line IV-IV in FIG. 9A.
FIG. 10A is a perspective view showing the structure of a composite heat transfer member according to the second modification example of the first embodiment.
FIG. 10B is a cross-sectional view taken along the line V-V in FIG. 10A.
FIG. 11A is a cross-sectional view (1) of a composite heat transfer member according to a second embodiment that is in the production process.
FIG. 11B is a cross-sectional view (2) of the composite heat transfer member according to the second embodiment that is in the production process.
FIG. 12 is a cross-sectional view (3) of the composite heat transfer member according to the second embodiment that is in the production process.
FIG. 13A is a perspective view showing the structure of a tray of the second embodiment.
FIG. 13B is a cross-sectional view taken along the line VI-VI in FIG. 13A.
FIG. 14A is a perspective view showing the structure in a state where a plate is accommodated in the tray in the second embodiment.
FIG. 14B is a cross-sectional view taken along the line VII-VII in FIG. 14A.
FIG. 15 is a view showing the constitution of a casting device.
FIG. 16A is a perspective view showing the structure of the composite heat transfer member according to the second embodiment.
FIG. 16B is a cross-sectional view taken along the line VIII-VIII in FIG. 16A.
FIG. 17A is a perspective view showing the structure of a plate of a modification example of the second embodiment.
FIG. 17B is a cross-sectional view taken along the line IX-IX in FIG. 17A.
FIG. 18A is a perspective view showing the structure of a tray of a modification example of the second embodiment.
FIG. 18B is a cross-sectional view taken along the line X-X in FIG. 18A.
FIG. 19A is a perspective view showing the structure in a state where the plate is accommodated in the tray in the modification example of the second embodiment.
FIG. 19B is a cross-sectional view taken along the line XI-XI in FIG. 19A.
FIG. 20A is a perspective view showing the structure of a composite heat transfer member according to the modification example of the second embodiment.
FIG. 20B is a cross-sectional view taken along the line XII-XII in FIG. 20A.
FIG. 21A is a perspective view showing the structure of a composite heat transfer member according to a third embodiment.
FIG. 21B is a cross-sectional view taken along the line XIII-XIII in FIG. 21A.
FIG. 22 is a perspective view showing the structure of a plate of a fourth embodiment.
FIG. 23A is a perspective view showing the structure of a composite heat transfer member according to the fourth embodiment.
FIG. 23B is a cross-sectional view taken along the line XIV-XIV in FIG. 23A.
FIG. 24 is a view showing an example of a heat transfer pathway in the plate of the fourth embodiment.
FIG. 25A is a perspective view showing the structure of a plate of a modification example of the fourth embodiment.
FIG. 25B is a cross-sectional view taken along the line XV-XV in FIG. 25A.
FIG. 26A is a perspective view showing the structure of a composite heat transfer member according to the modification example of the fourth embodiment.
FIG. 26B is a cross-sectional view taken along the line XVI-XVI in FIG. 26A.
FIG. 27A is a perspective view showing the structure in a state where a plate is accommodated in a tray in a fifth embodiment.
FIG. 27B is a cross-sectional view taken along the line XVII-XVII in FIG. 27A.
FIG. 28A is a perspective view showing the structure of a composite heat transfer member according to the fifth embodiment.
FIG. 28B is a cross-sectional view taken along the line XVIII-XVIII in FIG. 28A.
FIG. 29A is a perspective view showing the structure of a plate of a modification example of the fifth embodiment.
FIG. 29B is a cross-sectional view taken along the line XIX-XIX in FIG. 29A.
FIG. 30A is a perspective view showing the structure in a state where the plate is accommodated in a tray in the modification example of the fifth embodiment.
FIG. 30B is a cross-sectional view taken along the line XX-XX in FIG. 30A.
FIG. 31A is a perspective view showing the structure of a composite heat transfer member according to the modification example of the fifth embodiment.
FIG. 31B is a cross-sectional view taken along the line XXI-XXI in FIG. 31A.
FIG. 32A is a perspective view showing the structure of a composite heat transfer member according to a sixth embodiment.
FIG. 32B is a cross-sectional view taken along the line XXII-XXII in FIG. 32A.
FIG. 33 is a perspective view showing the structure of a tray of a seventh embodiment.
FIG. 34 is a perspective view showing the structure in a state where an XZ heat transfer member and an XY heat transfer member are accommodated in the tray in the seventh embodiment.
FIG. 35A is a perspective view showing the structure of a composite heat transfer member according to the seventh embodiment.
FIG. 35B is a cross-sectional view taken along the line XXIII-XXIII in FIG. 35A.
FIG. 36 is a perspective view showing the structure of a tray of a modification example of the seventh embodiment.
FIG. 37 is a perspective view showing the structure in a state where an XZ heat transfer member and an XY heat transfer member are accommodated in the tray in the modification example of the seventh embodiment.
FIG. 38A is a perspective view showing the structure of a composite heat transfer member according to a modification example of the seventh embodiment.
FIG. 38B is a cross-sectional view taken along the line XXIV-XXIV in FIG. 38A.
FIG. 39 is a perspective view showing a composite heat transfer member according to an eighth embodiment.
FIG. 40 is a perspective view showing the constitution of a plate included in the composite heat transfer member according to the eighth embodiment.
FIG. 41 is a perspective view showing the constitution of a portion of the plate included in the composite heat transfer member according to the eighth embodiment.
FIG. 42 is a view showing an example of a heat transfer pathway in the plate of the eighth embodiment.
FIG. 43 is a partial cross-sectional view showing a composite heat transfer member according to a ninth embodiment.
FIG. 44 is a partial cross-sectional view showing a composite heat transfer member according to a first modification example of the ninth embodiment.
FIG. 45 is a partial cross-sectional view showing a composite heat transfer member according to a second modification example of the ninth embodiment.
FIG. 46 is a partial cross-sectional view showing a composite heat transfer member according to a third modification example of the ninth embodiment.
FIG. 47A is a perspective view showing the constitution of a composite heat transfer member according to a tenth embodiment.
FIG. 47B is a top view showing the structure of the composite heat transfer member according to the tenth embodiment.

### BEST MODE FOR CARRYING OUT THE INVENTION

### (First embodiment)

The composite heat transfer member according to the present embodiment will be described along with the production method thereof.

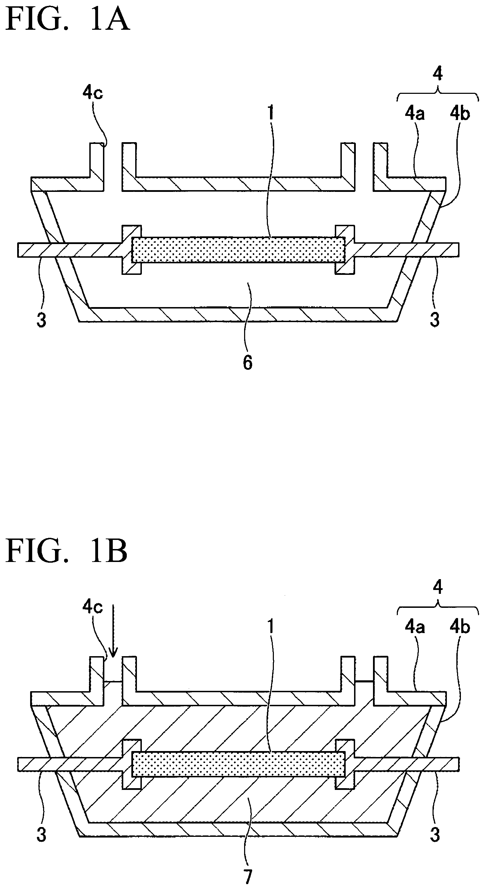

FIG. 1A to FIG. 2 are cross-sectional views of the composite heat transfer member according to the present embodiment that is in the production process.

In the present embodiment, as the composite heat transfer member, a heat spreader is produced in the following manner.

First, as shown in FIG. 1A, as one of the heat transfer members constituting the composite heat transfer member, a carbon plate 1 is prepared.

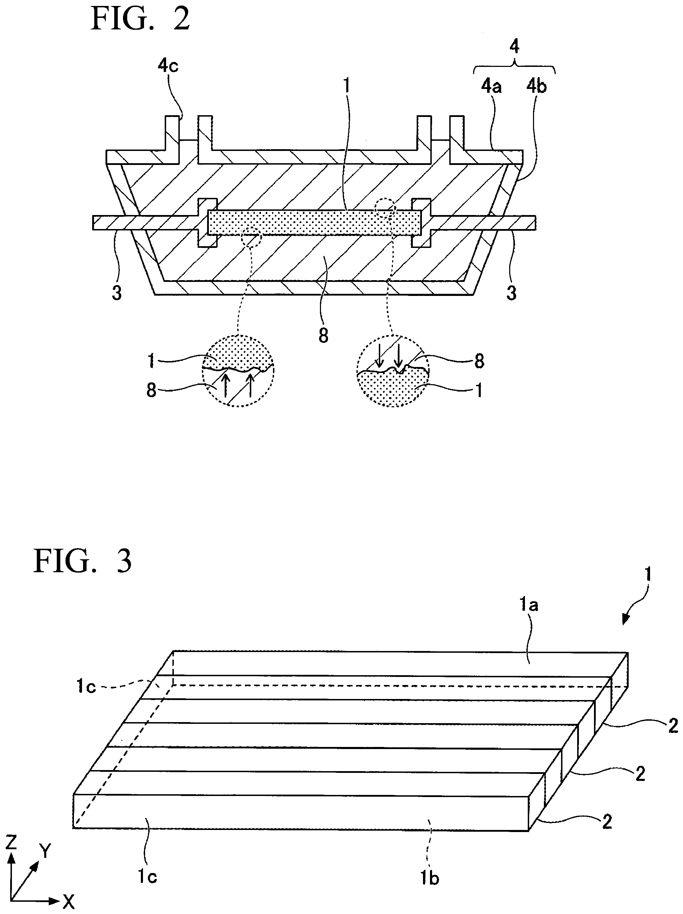

FIG. 3 is a perspective view showing the structure of the plate 1.

As shown in FIG. 3, the plate 1 is a plate-like heat transfer member obtained by laminating graphenes 2.

In the plate 1, the graphenes 2 are laminated in the Y direction. That is, the graphenes 2 are laminated in a direction perpendicular to the thickness direction (Z direction) of the plate 1.

The in-plane direction of the graphenes 2 is the X-Z direction.

Generally, in the laminate of the graphenes 2, the thermal conductivity in the in-plane direction of the graphenes 2 is higher than the thermal conductivity in the lamination direction of the graphenes 2.

Accordingly, the plate 1 has anisotropic thermal conductivity in which the thermal conductivity in the X direction and the Z direction is higher than the thermal conductivity in the Y direction. Hereinafter, the heat transfer member in which the thermal conductivity in the X direction and the Z direction is higher than the thermal conductivity in the Y direction will be called XZ heat transfer member as well.

In this case, in the plate 1, the thermal conductivity in the X direction and the Z direction is about 800 W/m·k, and the thermal conductivity in the Y direction is about 10 to 20 W/m.k.

The material of the plate 1 is not limited to the laminate of the graphenes 2. For example, as the material, graphite, Highly Oriented Pyrolytic Graphite (HOPG), or diamond can be used.

Atop surface 1a and a bottom surface 1b of the plate 1 are rectangular. The direction along which long sides of the top surface 1a and the bottom surface 1b extend is the X direction, and the direction along which short sides of the top surface 1a and the bottom surface 1b extend is the Y direction.

As shown in FIG. 1A, in the plate 1 having the structure described above, a fixing tool 3 is mounted on both ends in the X direction thereof. The plate 1 with the fixing tools is installed in the internal space of a lower portion 4b of a casting mold 4.

Then, an upper portion 4a of the casting mold is loaded on and fixed to the lower portion 4b. As a result, a cavity 6 is formed between the lower portion 4b and the upper portion 4a.

In this way, the plate 1 is disposed in the cavity 6 of the casting mold 4.

Thereafter, as shown in FIG. 1B, as a material of a cast-molded article which will be described later, a metal 7, which is melted at a temperature of about 700°C, is prepared and injected into the casting mold 4 from an injection port 4c of the upper portion 4a of the casting mold.

In this way, the molten metal 7 is supplied into the cavity 6 of the casting mold 4.

The type of the metal 7 is not particularly limited. For example, as the metal 7, a magnesium alloy or an aluminum alloy can be used.

In the present embodiment, as the metal 7, a magnesium alloy is used which is constituted with magnesium containing aluminum and zinc and has a thermal conductivity of about 51 to 100 W/m·k. By heating the magnesium alloy at a temperature of about 700°C, the molten metal 7 is formed.

The temperature of the casting mold 4 is lower than the solidification temperature (about 400°C) of the magnesium alloy.

Therefore, the molten metal 7 starts to be solidified immediately after being supplied into the cavity 6.

Then, as shown in FIG. 2, by decreasing the temperature of the metal 7 to about room temperature, a cast-molded article 8 is formed which covers the surfaces of the plate 1 except for the portions on which the fixing tool 3 is mounted.

At this time, the patterns of the surface asperities of the plate 1 are transferred to the cast-molded article 8, and consequently, the cast-molded article 8 contacts the surfaces of the plate 1 by surface-to-surface contact.

The magnesium alloy as a material of the cast-molded article 8 shrinks while the temperature thereof is being decreased to room temperature from the solidification temperature thereof. In contrast, while the temperature is being decreased as described above, the laminate of the graphenes 2 as a material of the plate 1 substantially does not shrink or slightly expands.

In this way, due to the difference in a coefficient of thermal expansion, a difference in shrinkage is caused between the cast-molded article 8 and the plate 1. Consequently, the cast-molded article 8 is pressed on the surfaces of the plate 1 as being indicated by the arrows in the circles of broken lines in FIG. 2.

As a result, the cast-molded article 8 is in tight contact with the surfaces of the plate 1.

Accordingly, the thermal resistance in the bonding interface between the cast-molded article 8 and the plate 1 is reduced, and the thermal conduction efficiency between the cast-molded article 8 and the plate 1 is improved.

Then, the upper portion 4a of the casting mold 4 is detached from the lower portion 4b, and the plate 1 and the cast-molded article 8 are taken out of the lower portion 4b together with the fixing tools 3. Thereafter, a portion of the plate 1 and the cast-molded article 8 is cut, and the fixing tools 3, residues, and the like are removed.

By the process described above, the basic structure of a composite heat transfer member 9 according to the present embodiment is completed.

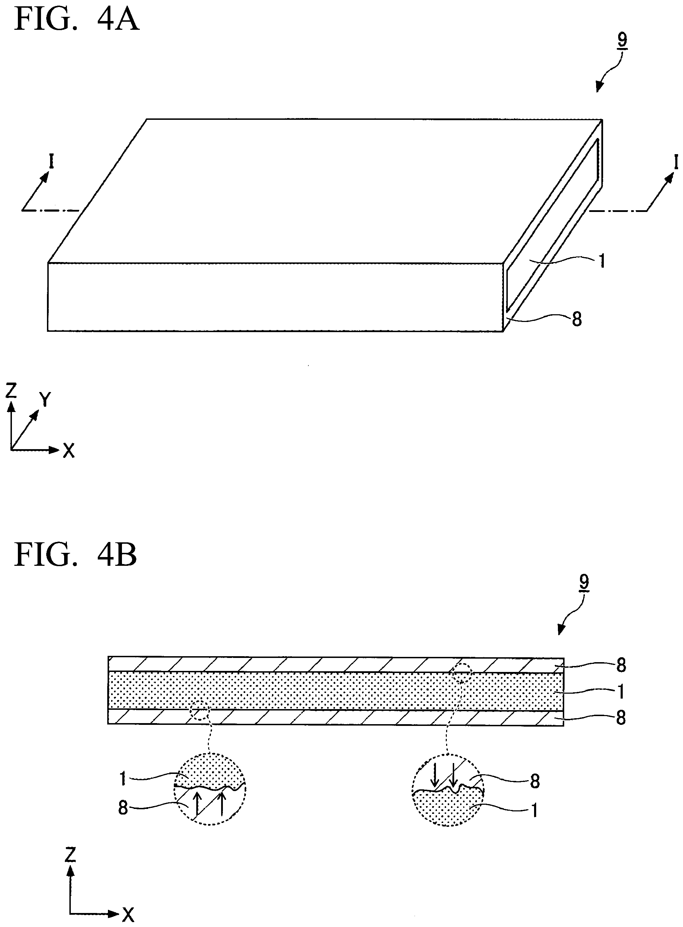

FIG. 4A is a perspective view showing the structure of the composite heat transfer member 9. FIG. 4B is a cross-sectional view taken along the line I-I of the structure.

As shown in FIG. 4A and FIG. 4B, the composite heat transfer member 9 includes the plate 1, which is the laminate of the graphenes 2, as a heat transfer member on one side and the cast-molded article 8 of a magnesium alloy, which covers the surfaces of the plate 1 except for lateral surfaces 1c in the X direction, as a heat transfer member on the other side.

The plate 1 is an XZ heat transfer member in which the thermal conductivity in the X direction and the Z direction is higher than the thermal conductivity in the Y direction. Therefore, basically, the composite heat transfer member 9 including the plate 1 is also an XZ heat transfer member.

However, because the surfaces of the plate 1 are covered with the cast-molded article 8 of a magnesium alloy, the thermal conductivity in the Y direction that is relatively low can also be increased.

As described above, in the composite heat transfer member 9 according to the present embodiment, the surfaces of the carbon plate 1 are covered with the metal cast-molded article 8.

Accordingly, the cast-molded article 8 contacts the surfaces of the plate 1 by surface-to-surface contact, and a difference in shrinkage is caused between the cast-molded article 8 and the plate 1. As a result, the cast-molded article 8 is pressed on the surfaces of the plate 1 as being indicated by the arrows in the circles of broken lines in FIG. 2.

As a result, the cast-molded article 8 is in tight contact with the surfaces of the plate 1. Consequently, the thermal resistance in the bonding interface between the cast-molded article 8 and plate 1 is reduced, and the thermal conductivity of the composite heat transfer member 9 can be improved even though a thermally conductive member or a thermally conductive adhesive is not used.

Furthermore, due to the difference in shrinkage that is caused between the cast-molded article 8 and the plate 1 at the time of forming the cast-molded article 8, even after the composite heat transfer member 9 is produced, residual tensile stress exists in the cast-molded article 8 while residual compressive stress exists in the plate 1.

For example, in a case where the composite heat transfer member 9 is used in a high-temperature environment with a temperature of about 150°C, the residual stresses are not lost even if being reduced. Therefore, the cast-molded article 8 remains pressed on the surfaces of the plate 1 as being indicated by the arrows in the circles of broken lines in FIG. 4B.

Accordingly, the excellent thermal conductivity between the cast-molded article 8 and the plate 1 can be maintained.

In the composite heat transfer member 9 according to the present embodiment, by the removal of the fixing tools 3, the lateral surfaces 1c of the plate 1 are exposed without being covered with the cast-molded article 8.

As described above, residual compressive stress exists in the plate 1. Therefore, in a case where the composite heat transfer member 9 is used in a high-temperature environment, it is possible to inhibit the composite heat transfer member 9 from thermally expanding along the X direction.

In the composite heat transfer member 9, by combining the plate 1, which is the laminate of the graphenes 2, with the cast-molded article 8 of a magnesium alloy, it is possible to obtain thermal conductivity approximately the same as the thermal conductivity of copper (391 W/m·k) and to greatly reduce the specific gravity of the composite heat transfer member 9 (2.1 g/cm³) compared to the specific gravity of copper (8.9 g/cm³).

Therefore, the composite heat transfer member 9 can be lightened or compactified.

In order to confirm that the thermal resistance in the composite heat transfer member 9 is really reduced, the inventor of the present application prepared a heat transfer member formed only of copper as a comparative example and calculated a thermal resistance ratio of each of the heat transfer member and the composite heat transfer member 9 according to the present embodiment.

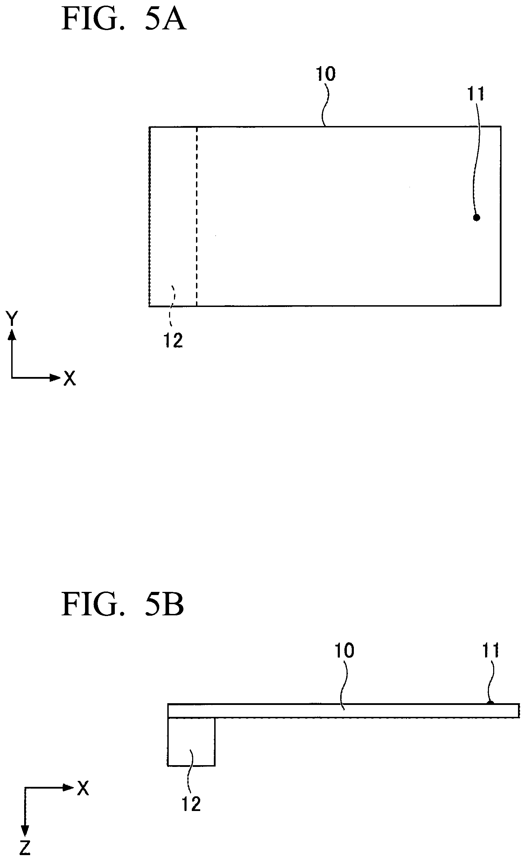

FIG. 5A is a top view showing the positional relationship among a model used for calculating the thermal resistance ratio, a pointlike heat source as a heating portion, and a cooling portion. FIG. 5B is a lateral view showing the positional relationship among these.

As shown in FIG. 5A and FIG. 5B, each of the composite heat transfer member 9 as a model 10 and the copper heat transfer member is 37 mm long in the Y direction and 3 mm long in the Z direction, that is, 3 mm thick. Furthermore, the thermal resistance ratio between a pointlike heat source 11 and a cooling portion 12 was calculated while varying the length of the model 10 in the X direction.

The pointlike heat source 11 is 1 mm long in the X direction and 1 mm long in the Y direction. The pointlike heat source 11 was disposed at a position 5 mm distant from one end of the model 10 in the X direction. Furthermore, the cooling portion 12 was disposed in a region extending 10 mm from another end of the model 10 in the X direction.

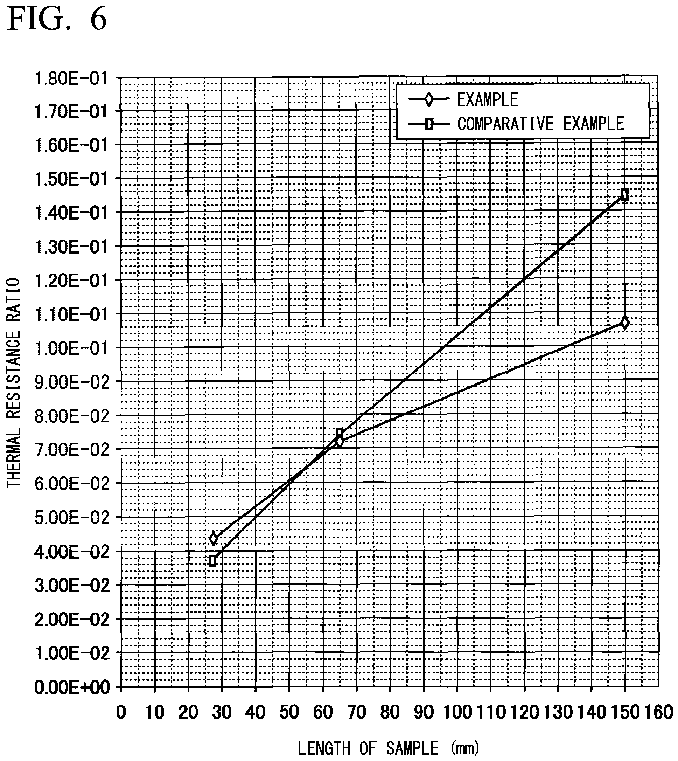

FIG. 6 is a graph showing the results obtained by calculating the thermal resistance ratio of the composite heat transfer member 9 of the present embodiment and the heat transfer member of the comparative example. In FIG. 6, the abscissa shows the length of the model 10 in the X direction, and the ordinate shows the thermal resistance ratio of a sample.

As shown in FIG. 6, until the length of the model 10 in the X direction is increased to 70 mm, the thermal resistance ratio of the heat transfer member of the comparative example remains lower than the thermal resistance ratio of the composite heat transfer member 9 of the present embodiment.

However, after the length of the model 10 in the X direction becomes greater than 70 mm, the thermal resistance ratio of the composite heat transfer member 9 of the present embodiment becomes lower than the thermal resistance ratio of the heat transfer member of the comparative example. For example, in a case where the length of the model 10 is 150 mm, the thermal resistance ratio of the composite heat transfer member 9 is reduced and becomes about 74% of the thermal resistance ratio of the heat transfer member of the comparative example.

By this result, it was confirmed that the composite heat transfer member 9 of the present embodiment has a thermal resistance reducing effect.

Next, modification examples of the present embodiment will be described.

### (First modification example)

In the first embodiment described above, as the plate 1, a plate of an XZ heat transfer member was used. However, in the present modification example, a plate of a heat transfer member having anisotropic thermal conductivity different from the anisotropic thermal conductivity of the XZ heat transfer member will be used.

In the present modification example, the same elements as those in the first embodiment will be marked with the same reference signs as those in the first embodiment and will not be described in the following section.

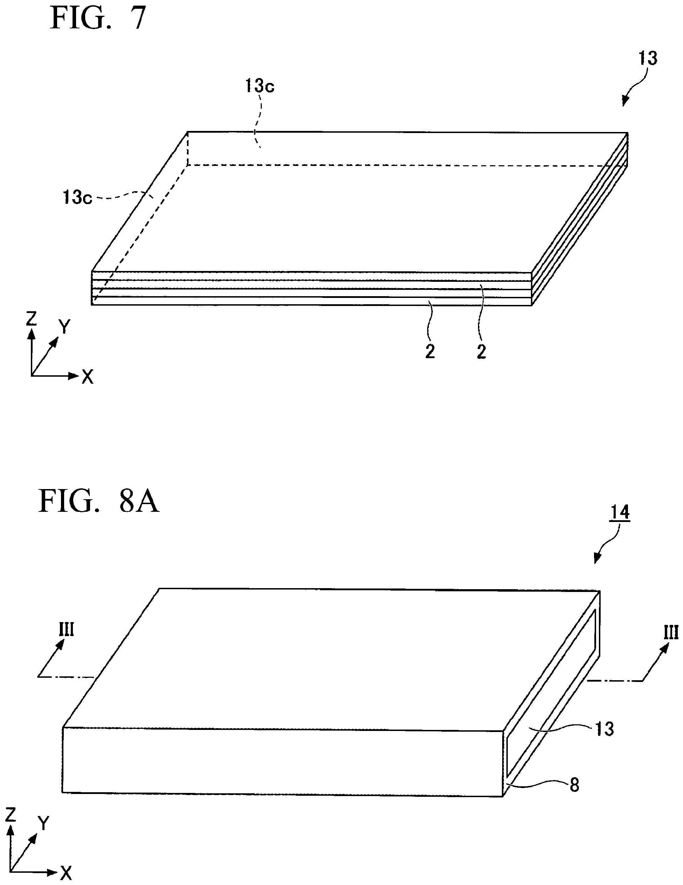

FIG. 7 is a perspective view showing the structure of the plate of the present modification example.

As shown in FIG. 7, a plate 13 is a thin plate-like heat transfer member formed of the laminate of the graphenes 2.

In the plate 13, the graphenes 2 are laminated in the thickness direction, that is, in the Z direction.

Therefore, the plate 13 has anisotropic thermal conductivity in which the thermal conductivity in the X direction and the Y direction is higher than the thermal conductivity in the Z direction. Hereinafter, the heat transfer member in which the thermal conductivity in the X direction and the Y direction is higher than the thermal conductivity in the Z direction will be called XY heat transfer member as well.

For the plate 13 having the structure described above, by performing the steps in the first embodiment shown in FIG. 1A to FIG. 2 and then removing the fixing tools 3, residues, and the like, the structure of a composite heat transfer member according to the present modification example is obtained.

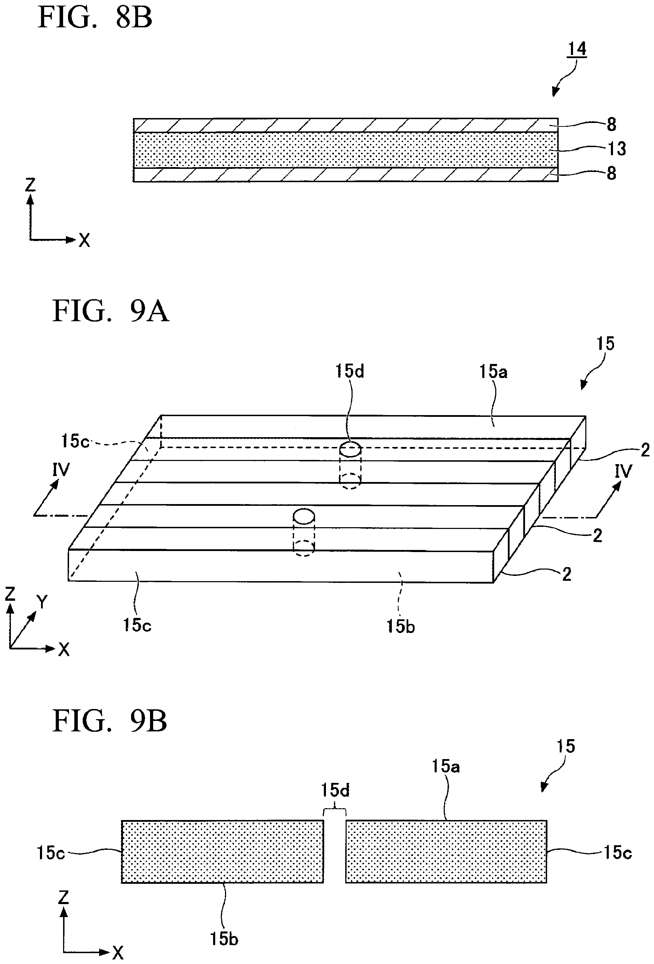

FIG. 8A is a perspective view showing the structure of the composite heat transfer member. FIG. 8B is a cross-sectional view taken along the line III-III of the structure.

As shown in FIG. 8A and FIG. 8B, a composite heat transfer member 14 according to the present modification example includes the plate 13, which is the laminate of the graphenes 2, and the cast-molded article 8 of a magnesium alloy covering the surfaces of the plate 13 except for lateral surfaces 13c in the X direction.

As described above, the plate 13 is an XY heat transfer member in which the thermal conductivity in the X direction and the Y direction is higher than the thermal conductivity in the Z direction. Therefore, basically, the composite heat transfer member 14 including the plate 13 is also an XY heat transfer member.

However, because the surfaces of the plate 13 are covered with the cast-molded article 8 of a magnesium alloy, the thermal conductivity in the Z direction that is relatively low can also be increased.

### (Second modification example)

In the present modification example, a plate having a shape different from the shape of the plate 1 will be used.

In the present modification example, the same elements as those in the first embodiment will be marked with the same reference signs as those in the first embodiment and will not be described in the following section.

FIG. 9A is a perspective view showing the structure of the plate of the present modification example. FIG. 9B is a cross-sectional view taken along the line IV-IV of the structure.

As shown in FIG. 9A and FIG. 9B, just as the plate 1 of the first embodiment, a plate 15 is a thin plate-like XZ heat transfer member formed of the laminate of the graphenes 2.

However, unlike the plate 1 of the first embodiment, the plate 15 of the present modification example is provided with through holes 15d that extend from a top surface 15a to a bottom surface 15b.

The position where the through holes 15d are provided and the number of the through holes 15d are not particularly limited. In the present embodiment, at the center of the plate 15 in the X direction, two through holes 15d that are spaced in the Y direction are provided.

For the plate 15 having the structure described above, by performing the steps in the first embodiment shown in FIG. 1A to FIG. 2 and then removing the fixing tools 3, residues, and the like, the structure of a composite heat transfer member according to the present modification example is obtained.

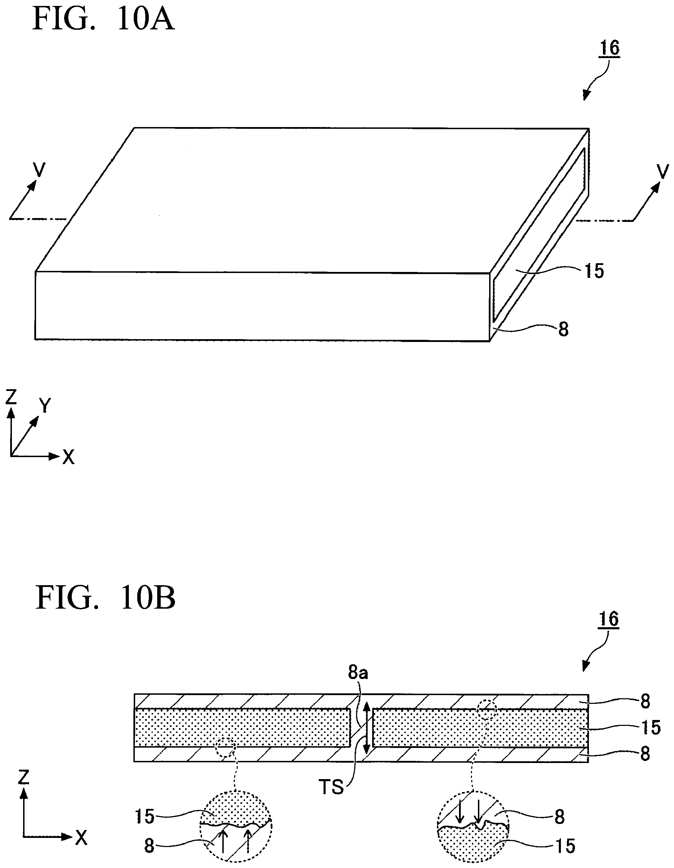

FIG. 10A is a perspective view showing the structure of the composite heat transfer member. FIG. 10B is a cross-sectional view taken along the line V-V of the structure.

As shown in FIG. 10A and FIG. 10B, a composite heat transfer member 16 according to the present modification example includes the plate 15, which is the laminate of the graphenes 2, and the cast-molded article 8 of a magnesium alloy covering the surfaces of the plate 15 except for lateral surfaces 15c in the X direction.

According to the present modification example, a portion 8a of the cast-molded article 8 fills up the through holes 15d of the plate 15.

As a result, through the portion 8a, the cast-molded article 8, which covers the top surface 15a of the plate 15, is connected to the cast-molded article 8 which covers the bottom surface 15b.

As described above, due to the difference in shrinkage that is caused between the cast-molded article 8 and the plate 15 at the time of forming the cast-molded article 8, residual tensile stress TS exists in the cast-molded article 8 as being indicated by the arrows.

Even though the composite heat transfer member 16 is used in a high-temperature environment, the residual tensile stress TS is not lost. Therefore, the cast-molded article 8 remains pressed on the surfaces of the plate 15 as being indicated by the arrows in the circles of broken lines. Accordingly, the excellent thermal conductivity between the cast-molded article 8 and the plate 15 can be maintained.

### (Second embodiment)

In the present embodiment, a composite heat transfer member is produced by a casting method different from the method in the first embodiment.

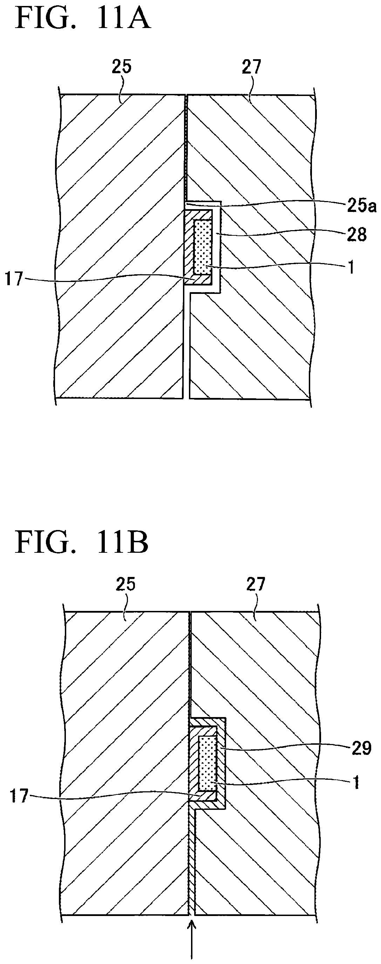

FIG. 11A to FIG. 12 are cross-sectional views of a composite heat transfer member according to the present embodiment that is in the production process. In FIG. 11A to FIG. 12, the same elements as those in the first embodiment will be marked with the same reference signs as those in the first embodiment and will not be described in the following section.

In the present embodiment, as the composite heat transfer member, a heat spreader will be produced in the following manner.

First, as shown in FIG. 11A, a carbon plate 1, which is one of the heat transfer members constituting the composite heat transfer member, and a metal tray 17 accommodating the plate 1 are prepared.

Among these, the plate 1 is a thin plate-like XZ heat transfer member formed of the laminate of the graphenes 2.

In contrast, the tray 17 has the following structure.

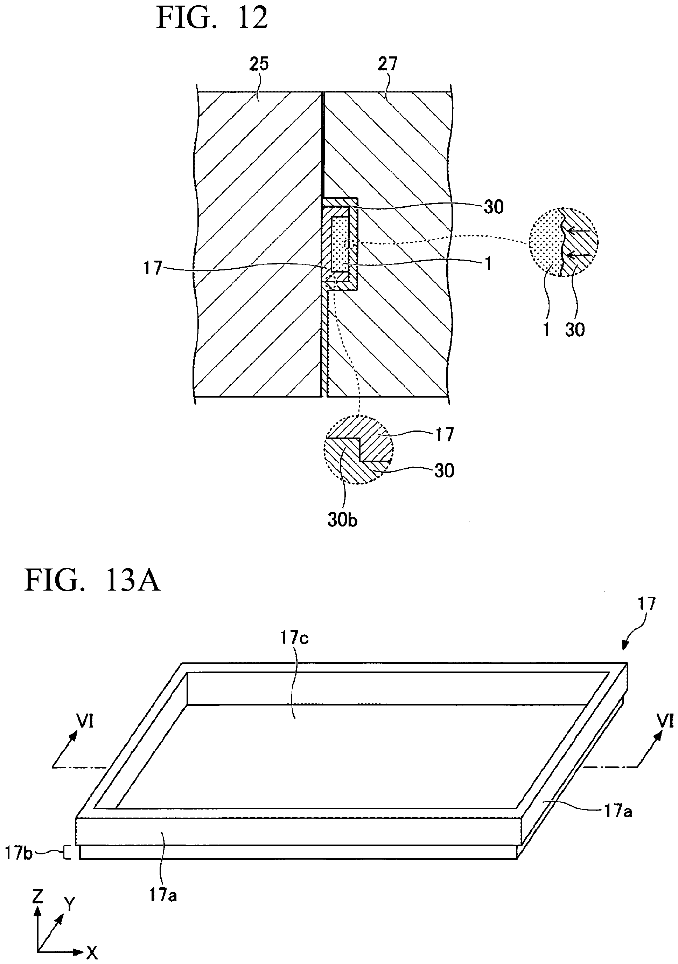

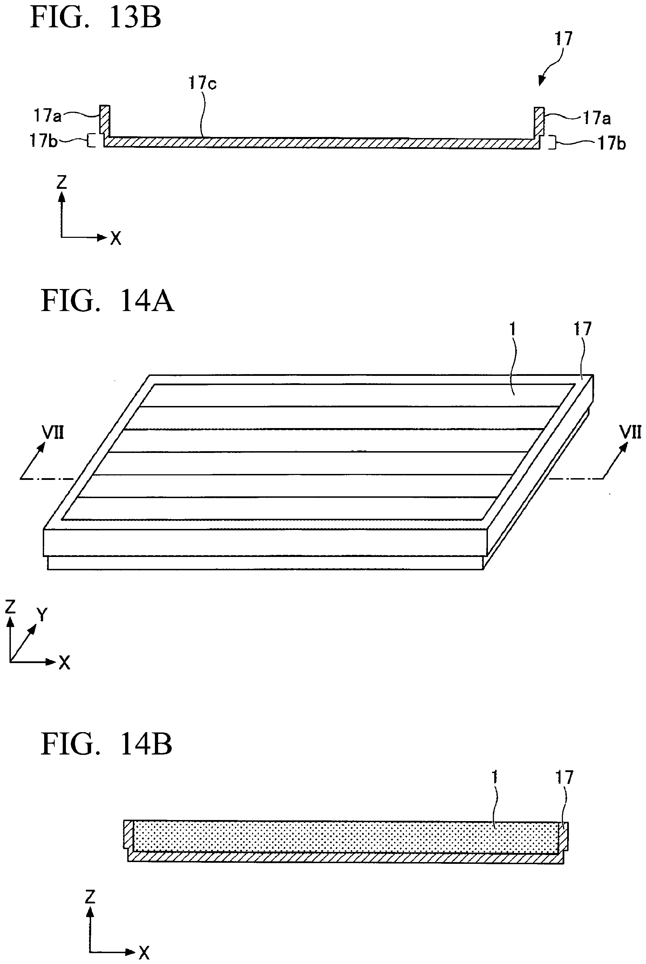

FIG. 13A is a perspective view showing the structure of the tray 17. FIG. 13B is a cross-sectional view taken along the line VI-VI of the structure.

As shown in FIG. 13A and FIG. 13B, the tray 17 is an open-top metal container with bottom.

The lower portion of each of outer lateral surfaces 17a of the tray 17 is provided with a depression 17b. The function of the depression 17b will be described later.

The type of metal forming the tray 17 is not particularly limited. For example, as the metal forming the tray 17, a magnesium alloy or an aluminum alloy can be used. In the present embodiment, as the metal, a magnesium alloy is used which is constituted with magnesium containing aluminum and zinc and has a thermal conductivity of about 51 to 100 W/m.k.

The method for preparing the tray 17 is not particularly limited. For example, the tray 17 can be obtained by a thixomolding method or a die casting method which will be described later.

After the plate 1 and the tray 17 having the structure described above are prepared, the plate 1 is accommodated in the tray 17.

FIG. 14A is a perspective view showing a structure in a state where the plate 1 is accommodated in the tray 17. FIG. 14B is a cross-sectional view taken along the line VII-VII of the structure.

As shown in FIG. 14A and FIG. 14B, the plate 1 is accommodated in the tray 17 such that the bottom surface 1b among the surfaces of the plate 1 contacts an inner bottom surface 17c of the tray 17 (see FIG. 13A and FIG. 13B).

As a result, the bottom surface 1b and the lateral surfaces 1c of the plate 1 are covered with the tray 17, and only the top surface 1a of the plate 1 is exposed.

Furthermore, in a state where the plate 1 is accommodated in the tray 17, the plate 1 and the tray 17 are disposed in the cavity of a mold of a casting device.

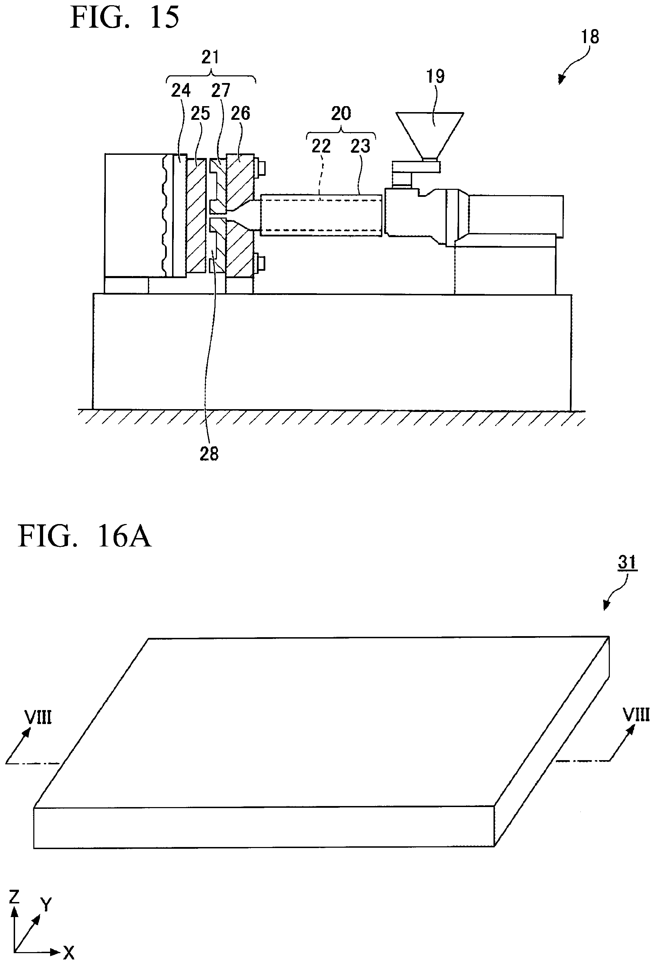

FIG. 15 is a view showing the constitution of the casting device. In FIG. 15, the cross-sectional structure of a portion of a molding portion, which will be described later, is also shown.

As shown in FIG. 15, a casting device 18 is a device producing a metal cast-molded article by a thixomolding method, and includes a raw material supply portion 19, a molten metal injection portion 20, and a molding portion 21.

Among these, the raw material supply portion 19 is connected to the molten metal injection portion 20, and supplies metal chips as a raw material of a molten metal, which will be described later, to the molten metal injection portion 20.

The type of metal chips as a raw material is not particularly limited. For example, as the metal chips, magnesium alloy chips or aluminum alloy chips can be used. In the present embodiment, as the metal chips, magnesium alloy chips are used which are constituted with magnesium containing aluminum and zinc and have a thermal conductivity of about 51 to 100 W/m·k.

The molten metal injection portion 20 melts the metal chips supplied from the raw material supply portion 19 and injects the molten metal into the molding portion 21 while applying pressure to the molten metal.

The molten metal injection portion 20 includes a cylinder 22, a heater 23 covering the outer surface of the cylinder 22, and a screw (not shown in the drawing) installed in the internal space of the cylinder 22. The operation of the cylinder 22, the heater 23, and the screw will be described later.

The molding portion 21 includes an immovable mold 25 mounted on a fixing board 24 and a movable mold 27 mounted on a moving board 26. By the movement of the movable mold 27, a cavity 28 between the immovable mold 25 and the movable mold 27 is closed (formed) or opened.

As shown in FIG. 11A, in the casting device 18 having the structure described above, in a state where the plate 1 is accommodated in the tray 17, the plate 1 and the tray 17 are loaded on a surface 25a of the immovable mold 25 and fixed by fixing tools not shown in the drawing, such that an outer bottom surface 17d of the tray 17 contacts the surface 25a of the immovable mold 25.

Then, the movable mold 27 is moved to the immovable mold 25 such that the cavity 28 is formed between the immovable mold 25 and the movable mold 27.

In this way, in the cavity 28 between the molds 25 and 27, the plate 1 and the tray 17 are disposed in a state where the plate 1 is accommodated in the tray 17.

Thereafter, a molten metal is supplied into the cavity 28 in the following manner.

First, in the molten metal injection portion 20 of the casting device 18, the cylinder 22 is preheated by the heater 23. In the present embodiment, magnesium allow chips are used as a raw material. Therefore, by the heater 23, the cylinder 22 is preheated to a temperature of about 600°C which is close to the melting point of the magnesium alloy.

In the molding portion 21, by a heater not shown in the drawing, the immovable mold 25 and the movable mold 27 are preheated to a temperature of about 300°C.

In the casting device 18 in this state, as a raw material, the magnesium alloy chips are put into the cylinder 22 from the raw material supply portion 19. Then, the screw not shown in the drawing is rotated in the cylinder 22.

As a result, in the cylinder 22, the magnesium alloy chips become in a semi-molten state in which solids and a liquid coexist. Furthermore, by the rotation of the screw, shear stress is applied to the magnesium alloy in the aforementioned state. Consequently, dendritic solid phases are finely shredded and become in the form of particles.

As a result, a thixotropic magnesium alloy with reduced viscosity and increased fluidity is formed in the cylinder 22. Furthermore, by the rotation of the screw, the thixotropic magnesium alloy is injected into the molding portion 21 as a molten metal 29 under pressure.

In this way, as shown in FIG. 11B, the molten metal 29 is supplied into the cavity 28 between the molds 25 and 27 of the molding portion 21.

As described above, the molds 25 and 27 are at a temperature of about 300°C which is lower than the solidification temperature (about 400°C) of the magnesium alloy. Therefore, the molten metal 29 starts to be solidified immediately after being supplied into the cavity 28.

Subsequently, as shown in FIG. 12, a heater (not shown in the drawing) of the molds 25 and 27 is turned off, such that the temperature of the metal 29 is reduced to about room temperature, and a cast-molded article 30 is formed which covers the outer lateral surfaces 17a of the tray 17 and the top surface 1a of the plate 1.

At this time, the patterns of the asperities of the outer lateral surfaces 17a of the tray 17 and the top surface 1a of the plate 1 are transferred to the cast-molded article 30. As a result, the cast-molded article 30 contacts the outer lateral surfaces 17a of the tray 17 and the top surface 1a of the plate 1 by surface-to-surface contact.

The magnesium alloy as a material of the cast-molded article 30 shrinks while the temperature thereof is being decreased to room temperature from the solidification temperature thereof. In contrast, while the temperature is being decreased as described above, the laminate of the graphenes 2 as a material of the plate 1 substantially does not shrink or slightly expands.

In this way, a difference in shrinkage is caused between the cast-molded article 30 and the plate 1 after the solidification of the molten metal 29, and accordingly, the cast-molded article 30 is pressed on the top surface 1a of the plate 1 as being indicated by the arrows in the circles of broken lines in FIG. 12.

As a result, the cast-molded article 30 is in tight contact with the top surface 1a of the plate 1.

Accordingly, the thermal resistance in the bonding interface between the cast-molded article 30 and the plate 1 is reduced, and the thermal conductivity between the cast-molded article 30 and the plate 1 is improved.

Furthermore, at the time of forming the cast-molded article 30, a portion of the cast-molded article 30 fills up the depression 17b of the outer lateral surfaces 17a of the tray 17. Consequently, a projection 30b fitted with the depression 17b is formed.

Then, the movable mold 27 is moved to be separated from the immovable mold 25, and the cast-molded article 30 that is covering the plate 1 and the tray 17 is taken out of the immovable mold 25.

Thereafter, a portion of the plate 1, the tray 17, and the cast-molded article 30 is cut, and the fixing tools not shown in the drawing, residues, and the like are removed.

In this way, the basic structure of a composite heat transfer member 31 according to the present embodiment is completed.

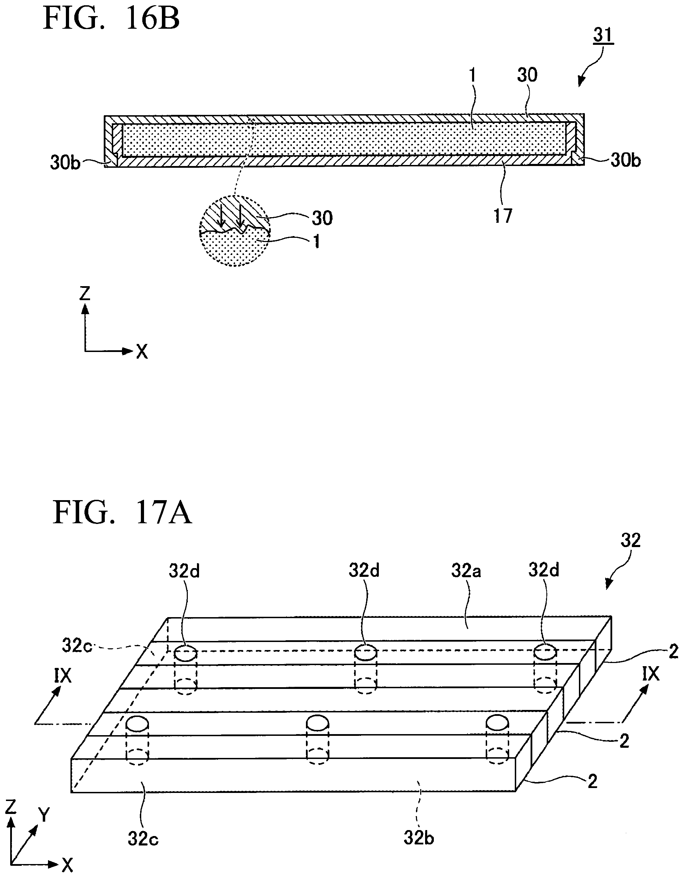

FIG. 16A is a perspective view showing the structure of the composite heat transfer member 31. FIG. 16B is a cross-sectional view taken along the line VIII-VIII of the structure.

As shown in FIG. 16A and FIG. 16B, the composite heat transfer member 31 includes the plate 1, which is the laminate of the graphenes 2, as a heat transfer member on one side, the tray 17 of a magnesium alloy, which covers the surfaces of the plate 1 except for the top surface 1a, as a heat transfer member on the other side, and the cast-molded article 30 of a magnesium alloy which covers the top surface 1a of the plate 1.

The plate 1 is an XZ heat transfer member in which the thermal conductivity in the X direction and the Z direction is higher than the thermal conductivity in the Y direction. Therefore, basically, the composite heat transfer member 31 including the plate 1 is also an XZ heat transfer member.

However, because the surfaces of the plate 1 are covered with the tray 17 and the cast-molded article 30 of a magnesium alloys, the thermal conductivity in the Y direction that is relatively low can also be increased.

As described above, in the composite heat transfer member 31 according to the present embodiment, the surfaces of the carbon plate 1 are covered with the metal tray 17 and the cast-molded article 30.

Particularly, the top surface 1a of the plate 1 is covered with the cast-molded article 30.

Accordingly, the cast-molded article 30 contacts the top surface 1a of the plate 1 by surface-to-surface contact, and a difference in shrinkage is caused between the cast-molded article 30 and the plate 1 at the time of forming the cast-molded article 30. As a result, the cast-molded article 30 is pressed on the top surface 1a of the plate 1.

Therefore, the cast-molded article 30 is in tight contact with the top surface 1a of the plate 1.

Consequently, the thermal resistance in the bonding interface between the cast-molded article 30 and the plate 1 is reduced, and as a result, it is possible to improve the thermal conductivity between the cast-molded article 30 and the plate 1 without using a thermally conductive member or a thermally conductive adhesive.

Furthermore, due to the difference in shrinkage that occurs between the cast-molded article 30 and the plate 1 at the time of forming the cast-molded article 30, even after the composite heat transfer member 31 is produced, residual tensile stress exists in the cast-molded article 30 while residual compressive stress exists in the plate 1.

In a case where the composite heat transfer member 31 is used in a high-temperature environment, the residual stresses are not lost. Therefore, the cast-molded article 30 remains pressed on the top surface 1a of the plate 1 as being indicated by the arrows in the circles of broken lines in FIG. 16B.

Accordingly, the excellent thermal conductivity between the cast-molded article 30 and the plate 1 can be maintained.

In the composite heat transfer member 31, by combining the plate 1, which is the laminate of the graphenes 2, with the tray 17 and the cast-molded article 30 of a magnesium alloy, it is possible to obtain thermal conductivity approximately the same as the thermal conductivity of copper and to greatly reduce the specific gravity of the composite heat transfer member 31 compared to the specific gravity of copper.

Therefore, the composite heat transfer member 31 can be lightened or compactified.

In addition, because the plate 1 is accommodated in the metal tray 17, it is easy to handle the plate 1 which has a brittle composition and is easily broken.

Moreover, according to the present embodiment, the projection 30b of the cast-molded article 30 is fitted with the depression 17b of the outer lateral surfaces 17a of the tray 17. Therefore, it is possible to inhibit the cast-molded article 30 from being detached from the tray 17.

In the embodiment described above, the cast-molded article 30 is formed by a thixomolding method. However, the method for forming the cast-molded article 30 is not particularly limited. For example, the cast-molded article may be formed by a die casting method.

Furthermore, although the plate 1 as an XZ heat transfer member is accommodated in the tray 17, the plate 13 as an XY heat transfer member shown in FIG. 7 may be accommodated in the tray 17. In addition, a desired heat transfer pathway may be formed of a plate as an XZ heat transfer member and a plate as an XY heat transfer member, and the plates may be accommodated in the tray 17.

### (Modification example)

In the present modification example, a plate and a tray having shapes different from the shapes of the plate and the tray in the second embodiment will be used.

In the present modification example, the same elements as those in the second embodiment will be marked with the same reference signs as those in the second embodiment and will not be described in the following section.

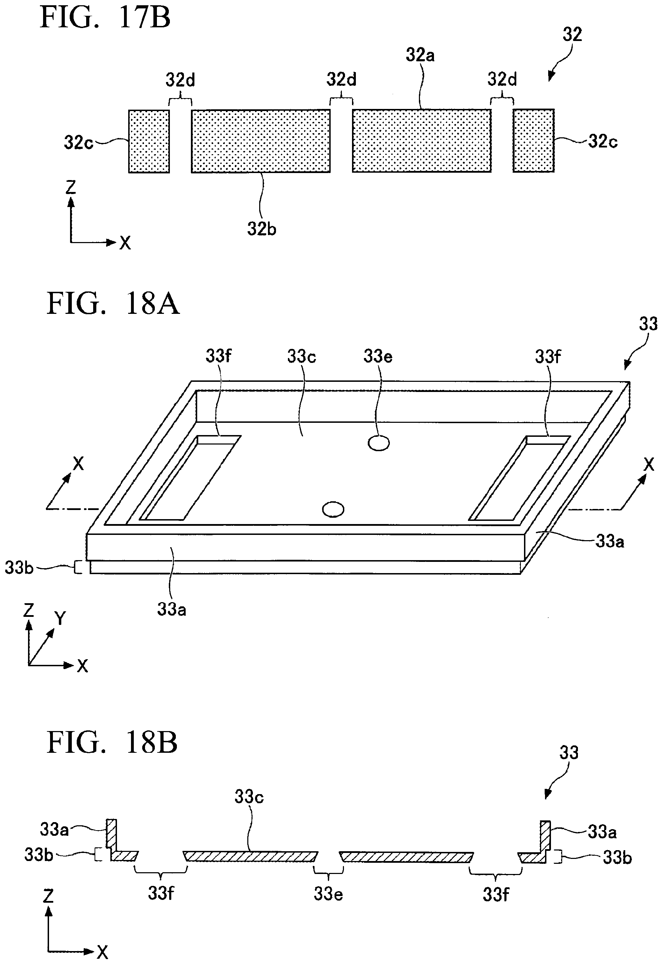

FIG. 17A is a perspective view showing the structure of the plate of the present modification example. FIG. 17B is a cross-sectional view taken along the line IX-IX of the structure.

As shown in FIG. 17A and FIG. 17B, just as the plate 1 of the second embodiment, a plate 32 is a thin plate-like XY heat transfer member formed of the laminate of the graphenes 2.

However, unlike the plate 1 of the second embodiment, the plate 32 of the present modification example is provided with through holes 32d that penetrate the plate from a top surface 32a to a bottom surface 32b.

The position where the through holes 32d are provided and the number of the through holes 32d are not particularly limited. In the present embodiment, at the left end, center, and right end of the plate 32 in the X direction, two through holes 32d that are spaced in the Y direction are provided.

FIG. 18A is a perspective view showing the structure of the tray of the present modification example. FIG. 18B is a cross-sectional view taken along the line X-X of the structure.

As shown in FIG. 18A and FIG. 18B, a tray 33 is an open-top metal container with bottom.

The lower portion of outer lateral surfaces 33a of the tray 33 is provided with a depression 33b.

First openings 33e are provided at the center of the bottom of the tray 33, and second openings 33f larger than the first opening 33e are provided at the left end and the right end of the bottom of the tray 33. The position where the openings 33e and 33f are provided and the number of the openings will be described later.

Each of the first openings 33e and the second openings 33f has a tapered shape having width decreasing toward an inner bottom surface 33c from an outer bottom surface 33d of the tray 33.

The type of metal forming the tray 33 is not particularly limited.

For example, as a metal forming the tray 33, a magnesium alloy or an aluminum alloy can be used. In the present embodiment, as the metal, a magnesium alloy is used which is constituted with magnesium containing aluminum and zinc and has a thermal conductivity of about 51 to 100 W/m·k.

The method for preparing the tray 33 is not particularly limited. For example, the tray 33 can be prepared by a thixomolding method or a die casting method.

After the plate 32 and the tray 33 having the structure described above are prepared, the plate 32 is accommodated in the tray 33.

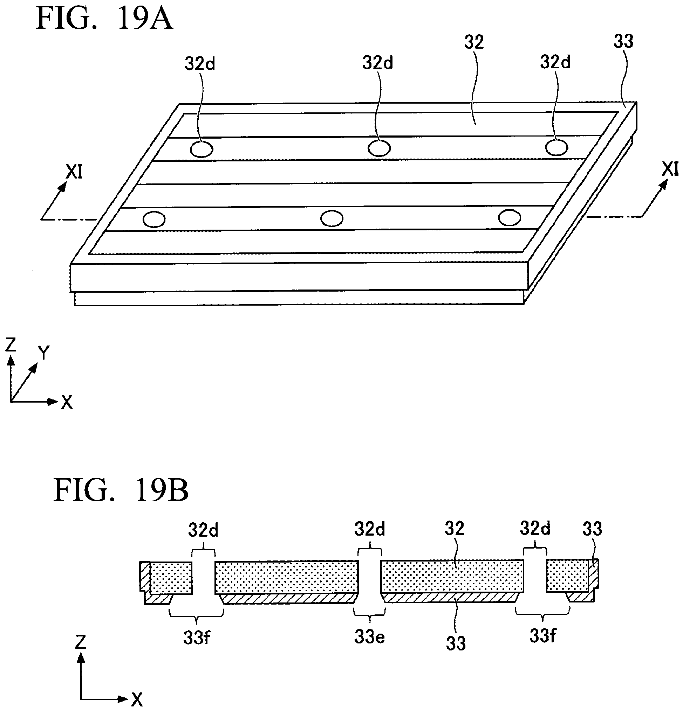

FIG. 19A is a perspective view showing a structure in a state where the plate 32 is accommodated in the tray 33. FIG. 19B is a cross-sectional view taken along the line XI-XI of the structure.

As shown in FIG. 19A and FIG. 19B, the plate 32 is accommodated in the tray 33 such that a bottom surface 32b among the surfaces of the plate 32 contacts an inner bottom surface 33c of the tray 33 (see FIG. 18A and FIG. 18B).

As a result, the bottom surface 32b and lateral surfaces 32c of the plate 32 are covered with the tray 33, and only the top surface 32a of the plate 32 is exposed.

Furthermore, among the through holes 32d of the plate 32, two through holes 32d at the center communicate with two first openings 33e at the center of the tray 33 along the thickness direction (Z direction) of the plate 32.

Two through holes 32d at the right end portion communicate with two second openings 33f, which are larger than the through holes 32d and positioned at the left end of the tray 33, along the Z direction. Two through holes 32d at the right end communicate with two second openings 33f, which are larger than the through holes 32d and positioned at the right end of the tray 33, along the Z direction.

For the plate 32 and the tray 33 that are in a state where the plate 32 is accommodated in the tray 33, by performing the steps in the second embodiment shown in FIG. 11A to FIG. 12 and then removing the fixing tools, residues, and the like, a structure of a composite heat transfer member according to the present modification example is obtained.

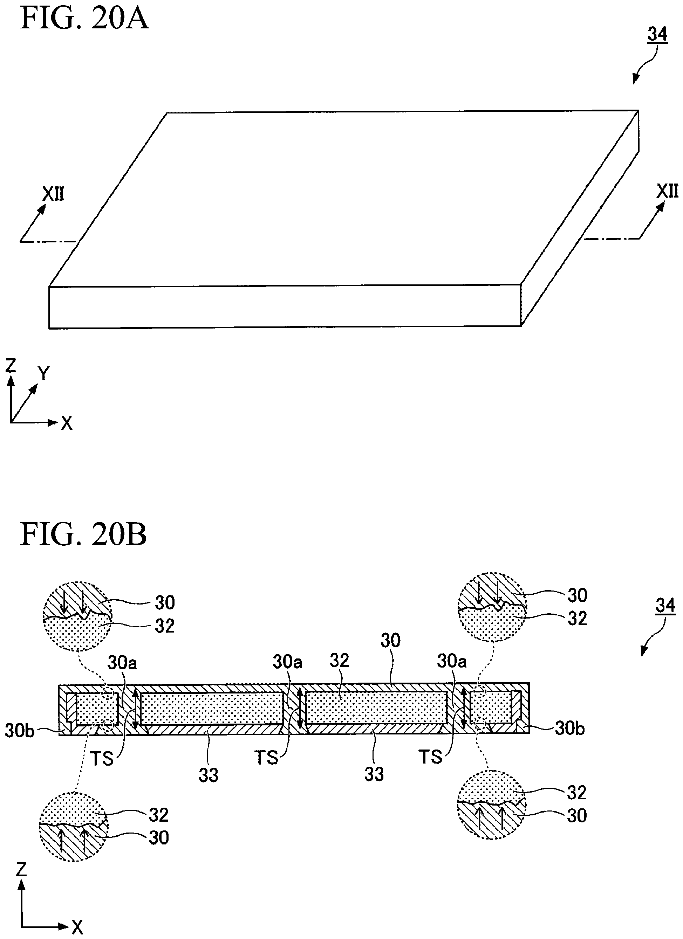

FIG. 20A is a perspective view showing the structure of the composite heat transfer member. FIG. 20B is a cross-sectional view taken along the line XII-XII of the structure.

As shown in FIG. 20A and FIG. 20B, a composite heat transfer member 34 according to the present modification example includes the plate 32, which is the laminate of the graphenes 2, as a heat transfer member on one side, the tray 33 of a magnesium alloy, which covers the surfaces of the plate 32 except for the top surface 32a, as a heat transfer member on the other side, and the cast-molded article 30 of a magnesium alloy which covers the top surface 32a of the plate 32.

According to the present modification example, a portion 30a of the cast-molded article 30 fills up the through holes 32d of the plate 32 and the openings 33e and 33f of the tray 33.

As a result, through the portion 30a, the cast-molded article 30 covering the top surface 32a of the plate 32 is connected to the cast-molded article 30 covering the bottom surface 32b.

As described above, due to the difference in shrinkage that is caused between the cast-molded article 30 and the plate 32 at the time of forming the cast-molded article 30, even after the composite heat transfer member 34 is produced, residual tensile stress TS exists in the cast-molded article 30 as being indicated by the arrows.

In a case where the composite heat transfer member 34 is used in a high-temperature environment, the residual tensile stress TS is not lost. Therefore, the cast-molded article 30 remains pressed on the top surface 32a of the plate 32 as being indicated by the arrows in the circles of broken lines.

The second openings 33f of the tray 33 are larger than the through holes 32d of the plate 32 that communicate with the second openings 33f.

Accordingly, by the portion 30a of the cast-molded article 30 that fills up the second openings 33f, the cast-molded article 30 can also remain pressed on the bottom surface 32b of the plate 32 as being indicated by the arrows in the circles of broken lines.

As a result, further improved thermal conductivity can be maintained between the cast-molded article 30 and the plate 32.

In addition, according to the present modification example, the projection 30b of the cast-molded article 30 is fitted with the depression 33b of outer lateral surfaces 33a of the tray 33. Furthermore, the portion 30a of the cast-molded article 30 is fitted with the tapered first openings 33e and the tapered second openings 33f at the bottom of the tray 33.

Consequently, it is possible to more reliably inhibit the cast-molded article 30 from being detached from the tray 33.

### (Third embodiment)

In the first embodiment and the second embodiment, as a composite heat transfer member, a heat spreader was produced. However, in the present embodiment, as a composite heat transfer member, a heat spreader that also functions as a heat sink will be produced.

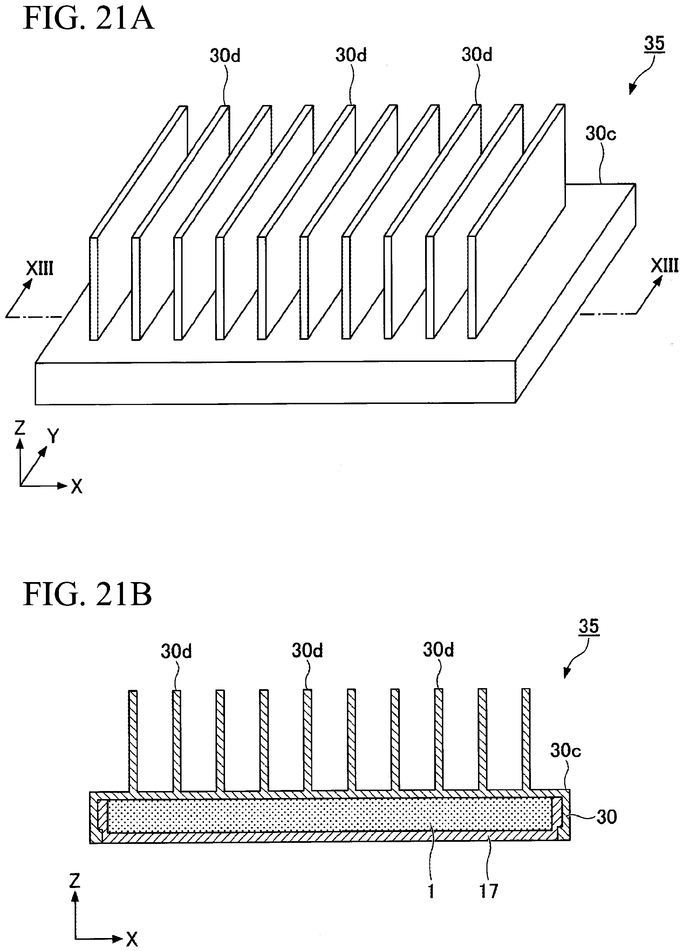

FIG. 21A is a perspective view showing the structure of the composite heat transfer member. FIG. 21B is a cross-sectional view taken along the line XIII-XIII of the structure. In FIG. 21A and FIG. 21B, the same elements as those in the second embodiment will be marked with the same reference signs as those in the second embodiment and will not be described in the following section.

As shown in FIG. 21A and FIG. 21B, basically, a composite heat transfer member 35 according to the present embodiment has the same structure as the structure of the composite heat transfer member 31 according to the second embodiment.

That is, the composite heat transfer member 35 also includes the plate 1, which is the laminate of the graphenes 2, as a heat transfer member on one side, the tray 17 of a magnesium alloy, which covers the surfaces of the plate 1 except for the top surface 1a, as a heat transfer member on the other side, and the cast-molded article 30 of a magnesium alloy which covers the top surface 1a of the plate 1.

In the composite heat transfer member 35, a plurality of fins 30d are provided on the outer top surface 30c of the cast-molded article 30.

In a case where a movable mold for forming the fins 30d is used instead of the movable mold 27 used in the second embodiment, the composite heat transfer member 35 having the structure described above can be obtained by performing the same steps as the steps in the second embodiment shown in FIG. 11A to FIG. 12.

In this way, according to the present embodiment, the fins 30d are provided on the cast-molded article 30.

Therefore, by the composite heat transfer member 35, the heat generated from electronic components or electronic instruments can be moved and dissipated from the fins 30d.

The cast-molded article 30 and the fins 30d are integrated. Accordingly, in this case, thermal resistance can be further reduced than in a case where a cast-molded article and fins are separately provided, because a thermally conductive member or a thermally conductive adhesive for bonding the cast-molded article to the fins is not used.

Basically, the composite heat transfer member 35 according to the present embodiment has the same structure as the structure of the composite heat transfer member 31 according to the second embodiment. However, the composite heat transfer member 35 is not limited to the structure.

For example, the composite heat transfer member according to the present embodiment may have a structure that is basically the same as the structure of the composite heat transfer member 9 according to the first embodiment. In this case, a plurality of fins may be provided on the outer top surface of the cast-molded article 8.

### (Fourth embodiment)

In the first embodiment, as the plate 1, a plate which is an XZ heat transfer member was used. However, in the present modification example, a plate will be used which is constituted with heat transfer members having two kinds of anisotropic thermal conductivity.

In the present embodiment, the same elements as those in the first embodiment will be marked with the same reference signs as those in the first embodiment and will not be described in the following section.

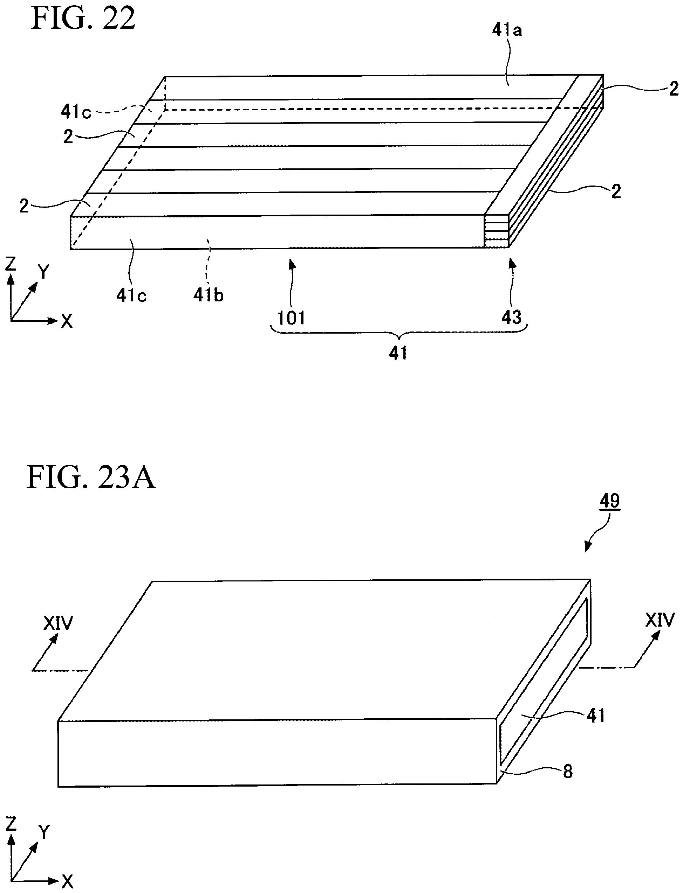

FIG. 22 is a perspective view showing the structure of the plate of the present embodiment.

As shown in FIG. 22, a plate 41 includes a heat transfer member 101 and a heat transfer member 43.

The heat transfer member 101 has the same structure as the structure of the plate 1. That is, in the heat transfer member 101, the graphenes 2 are laminated in the Y direction, and the in-plane direction of the graphenes 2 is the X-Z direction. Accordingly, the heat transfer member 101 is an XZ heat transfer member.

The heat transfer member 43 is a thin plate-like heat transfer member formed of the laminate of the graphenes 2. In the heat transfer member 43, the graphenes 2 are laminated in the thickness direction of the heat transfer member 43, that is, in the Z direction, and the in-plane direction of the graphenes 2 is the X-Y direction. Accordingly, the heat transfer member 43 is an XY heat transfer member.

For example, the dimension of the heat transfer member 43 in the Y direction is identical to the dimension of the heat transfer member 101 in the Y direction, one lateral surface of the heat transfer member 101 in the X direction contacts a lateral surface of the heat transfer member 43 in the X direction, and one end of the heat transfer member 101 in the X direction is connected to the heat transfer member 43.

A top surface 41a and a bottom surface 41b of the plate 41 are rectangular. The direction along which long sides of the top surface 41a and the bottom surface 41b extend is the X direction, and the direction along which short sides of the top surface 41a and the bottom surface 41b extend is the Y direction.

For the plate 41 having the structure described above, by performing the steps in the first embodiment shown in FIG. 1A to FIG. 2 and then removing the fixing tools 3, residues, and the like, a structure of a composite heat transfer member according to the present embodiment is obtained.

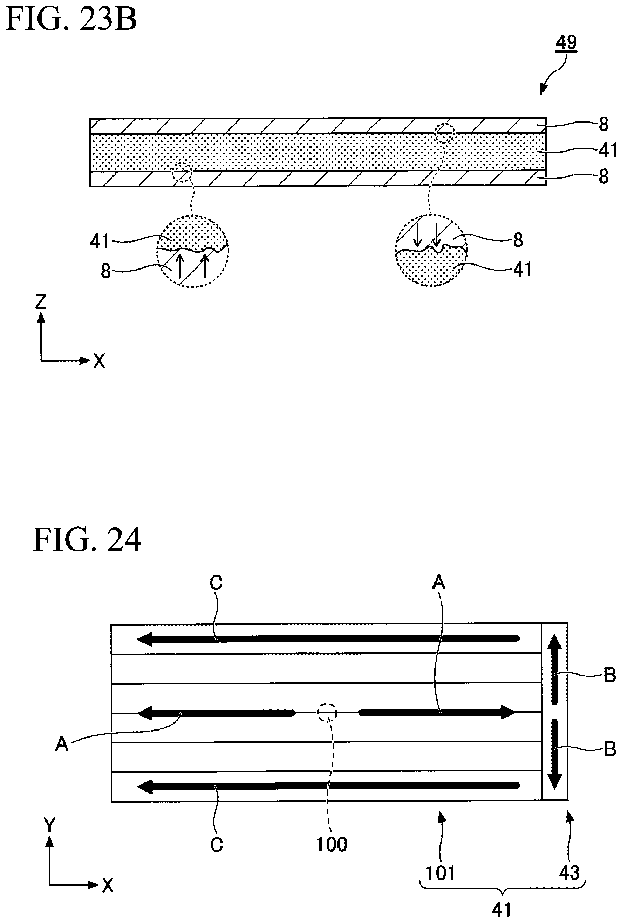

FIG. 23A is a perspective view showing the structure of the composite heat transfer member. FIG. 23B is a cross-sectional view taken along the line XIV-XIV of the structure.

As shown in FIG. 23A and FIG. 23B, a composite heat transfer member 49 according to the present embodiment includes the plate 41, which the laminate of the graphenes 2, and the cast-molded article 8 of a magnesium alloy which covers the surfaces of the plate 41 except for lateral surfaces 41c in the X direction.

The heat transfer pathway in the composite heat transfer member 49 will be described. FIG. 24 is a view showing an example of a heat transfer pathway in the plate 41 of the fourth embodiment. FIG. 24 shows the heat transfer pathway in the X-Y plane. In FIG. 24, a heat source 100 is assumed to be at the center of the bottom surface 41b of the plate 41.

First, the heat generated from the heat source 100 is transferred along the Z direction through graphene positioned around the center of the Y direction among the graphenes 2 constituting the heat transfer member 101, and transferred along the X direction as well (arrow A). Thereafter, a portion of the heat is transferred to the heat transfer member 43 at one end of the heat transfer member 101 in the X direction. The heat is then transferred along the X direction through the heat transfer member 43 and transferred along the Y direction as well (arrow B). A portion of the heat transferred through the heat transfer member 43 is transferred to the heat transfer member 101. The heat is then transferred along the Z direction through the heat transfer member 101 and transferred along the X direction as well (arrow C). Because the plate 41 is in tight contact with the cast-molded article 8, the heat is released out of the cast-molded article 8.

Therefore, according to the fourth embodiment, it is possible to obtain the same effect as that in the first embodiment and to obtain excellent thermal conductivity in the X direction and the Y direction. For example, due to the difference in shrinkage that is caused between the cast-molded article 8 and the plate 41 at the time of forming the cast-molded article 8, even after the composite heat transfer member 49 is produced, residual tensile stress exists in the cast-molded article 8 while residual compressive stress exists in the plate 41. Furthermore, for example, even though the composite heat transfer member 49 is used in a high-temperature environment with a temperature of about 150°C, the residual stresses are not lost even if being reduced. Therefore, the cast-molded article 8 remains pressed on the surfaces of the plate 41 as being indicated by the arrows in the circles of broken lines in FIG. 23B. Accordingly, the excellent thermal conductivity between the cast-molded article 8 and the plate 41 can be maintained.

### (Modification example)

In the present modification example, a plate having a shape different from the shape of the plate 41 will be used.

In the present modification example, the same elements as those in the fourth embodiment will be marked with the same reference signs as those in the fourth embodiment and will not be described in the following section.

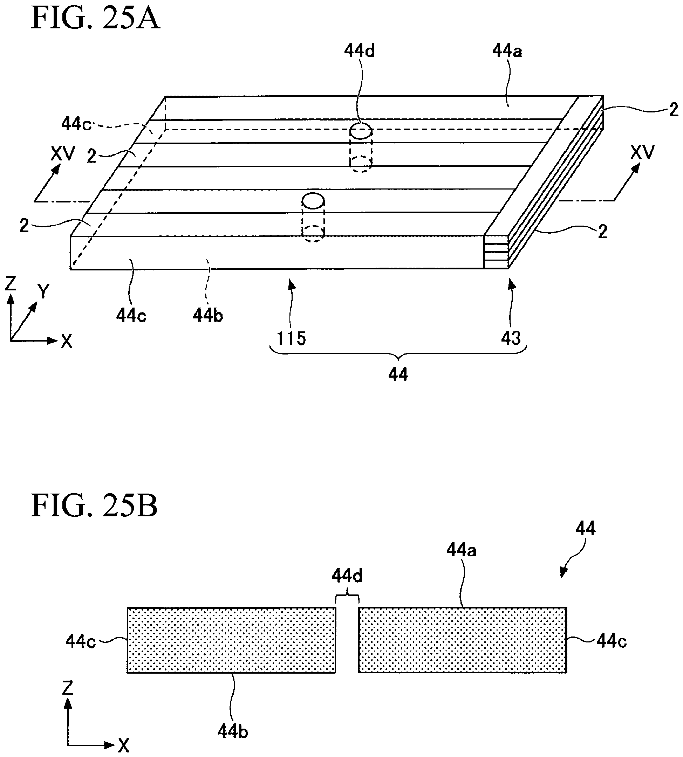

FIG. 25A is a perspective view showing the structure of the plate of the present modification example. FIG. 25B is a cross-sectional view taken along the line XV-XV of the structure.

As shown in FIG. 25A and FIG. 25B, a plate 44 includes a heat transfer member 115 instead of the heat transfer member 101. The heat transfer member 115 has the same structure as the structure of the plate 15. That is, the heat transfer member 115 is a thin plate-like XZ heat transfer member which is formed of the laminate of the graphenes 2 and is provided with through holes 44d that extend from a top surface 44a to a bottom surface 44b.

For the plate 44 having the structure described above, by performing the steps in the first embodiment shown in FIG. 1A to FIG. 2 and then removing the fixing tools 3, residues, and the like, a structure of a composite heat transfer member according to the present modification example is obtained.

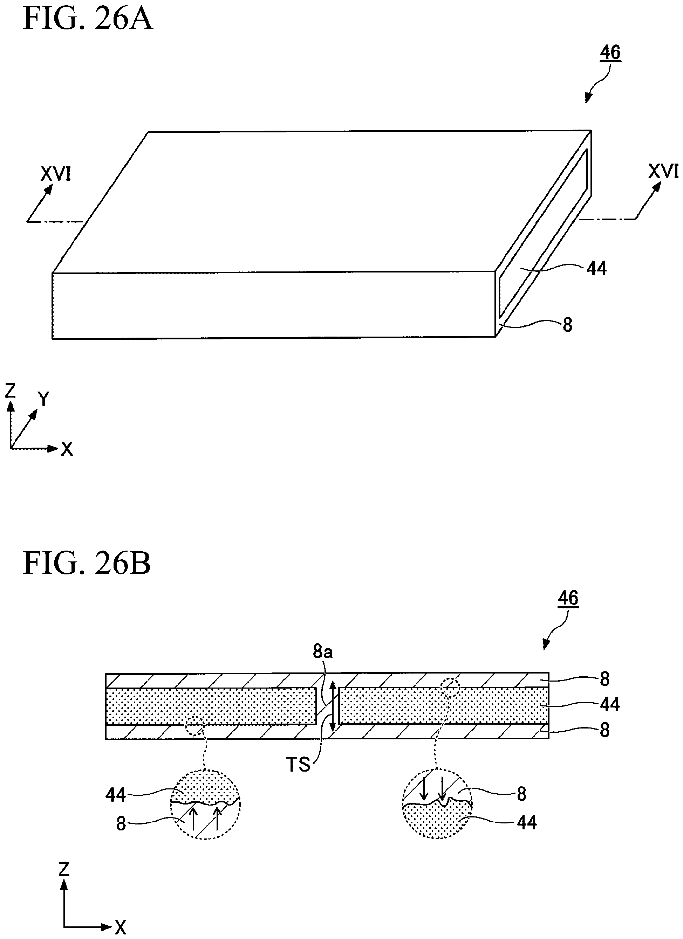

FIG. 26A is a perspective view showing the structure of the composite heat transfer member. FIG. 26B is a cross-sectional view taken along the line XVI-XVI of the structure.

As shown in FIG. 26A and FIG. 26B, a composite heat transfer member 46 according to the present modification example includes the plate 44, which is the laminate of the graphenes 2, and the cast-molded article 8 of a magnesium alloy which covers the surfaces of the plate 44 except for lateral surfaces 44c in the X direction.

According to the present modification example, a portion 8a of the cast-molded article 8 fills up the through holes 44d of the plate 44.

As a result, through the portion 8a, the cast-molded article 8 covering the top surface 44a of the plate 44 is connected to the cast-molded article 8 covering the bottom surface 44b.

As in the second modification example of the first embodiment, due to the difference in shrinkage that is caused between the cast-molded article 8 and the plate 44 at the time of forming the cast-molded article 8, residual tensile stress TS exists in the cast-molded article 8 as being indicated by the arrows.

Even though the composite heat transfer member 46 is used in a high-temperature environment, the residual tensile stress TS is not lost. Therefore, the cast-molded article 8 remains pressed on the surfaces of the plate 44 as being indicated by the arrows in the circles of broken lines. Therefore, the excellent thermal conductivity between the cast-molded article 8 and the plate 44 can be maintained.

### (Fifth embodiment)

In the present embodiment, a composite heat transfer member will be produced by a casting method different from the method in the fourth embodiment. That is, in the present embodiment, the plate 41 and the tray 17 shown in FIG. 13A and FIG. 13B are prepared, and a composite heat transfer member is produced by the same method as that in the second embodiment.

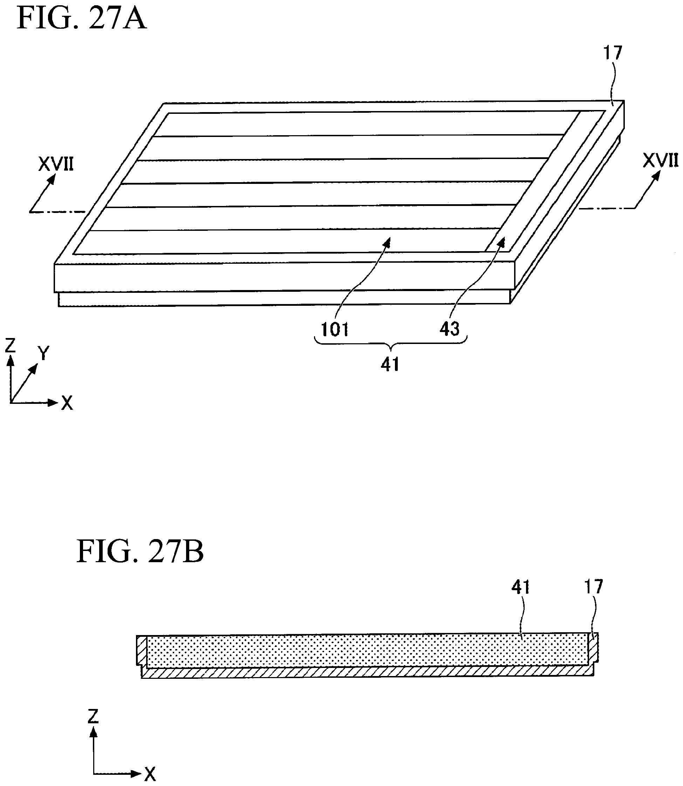

FIG. 27A is a perspective view showing a structure in a state where the plate 41 is accommodated in the tray 17. FIG. 27B is a cross-sectional view taken along the line XVII-XVII of the structure.

As shown in FIG. 27A and FIG. 27B, the plate 41 is accommodated in the tray 17 such that the bottom surface 41b among the surfaces of the plate 41 contacts the inner bottom surface 17c of the tray 17 (see FIG. 13A and FIG. 13B).

As a result, the bottom surface 41b and the lateral surfaces 41c of the plate 41 are covered with the tray 17, and only the top surface 41a of the plate 41 is exposed.

As in the second embodiment, the plate 41 and the tray 17 that are in a state where the plate 41 is accommodated in the tray 17 are disposed in the cavity 28 between the movable mold 27 and the immovable mold 25 of the casting device 18, and a molten metal is supplied into the cavity 28, thereby forming the cast-molded article 30.

Then, the movable mold 27 is moved to be separated from the immovable mold 25, and the cast-molded article 30 that is covering the plate 41 and the tray 17 is taken out of the immovable mold 25.

Thereafter, a portion of the plate 41, the tray 17, and the cast-molded article 30 is cut, and the fixing tools not shown in the drawing, residues, and the like are removed.

In this way, the basic structure of a composite heat transfer member 51 according to the present embodiment is completed.

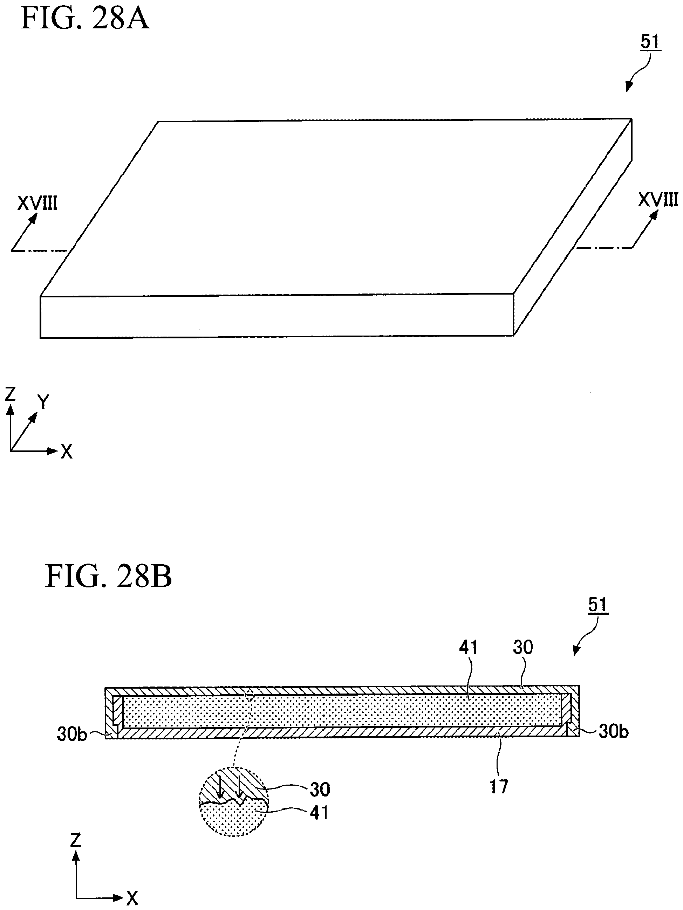

FIG. 28A is a perspective view showing the structure of the composite heat transfer member 51. FIG. 28B is a cross-sectional view taken along the line XVIII-XVIII of the structure.

As shown in FIG. 28A and FIG. 28B, the composite heat transfer member 51 includes the plate 41, which is the laminate of the graphenes 2, as a heat transfer member on one side, the tray 17 of a magnesium alloy, which covers the surfaces of the plate 41 except for the top surface 41a, as a heat transfer member on the other side, and the cast-molded article 30 of a magnesium alloy which covers the top surface 41a of the plate 41.

According to the fifth embodiment, it is possible to obtain the effects of the fourth embodiment and the second embodiment. For example, due to the difference in shrinkage that is caused between the cast-molded article 30 and the plate 41 at the time of forming the cast-molded article 30, even after the composite heat transfer member 51 is produced, residual tensile stress exists in the cast-molded article 30 while residual compressive stress exists in the plate 41. Furthermore, for example, even though the composite heat transfer member 51 is used in a high-temperature environment, the residual stresses are not lost. Therefore, the cast-molded article 30 remains pressed on the top surface 41a of the plate 41 as being indicated by the arrows in the circles of broken lines in FIG. 28B. Accordingly, the excellent thermal conductivity between the cast-molded article 30 and the plate 41 can be maintained.

### (Modification example)

In the present modification example, a plate and a tray having shapes different from the shapes of the plate and the tray in the fifth embodiment will be used.

In the present modification example, the same elements as those in the fifth embodiment will be marked with the same reference signs as those in the fifth embodiment and will not be described in the following section.

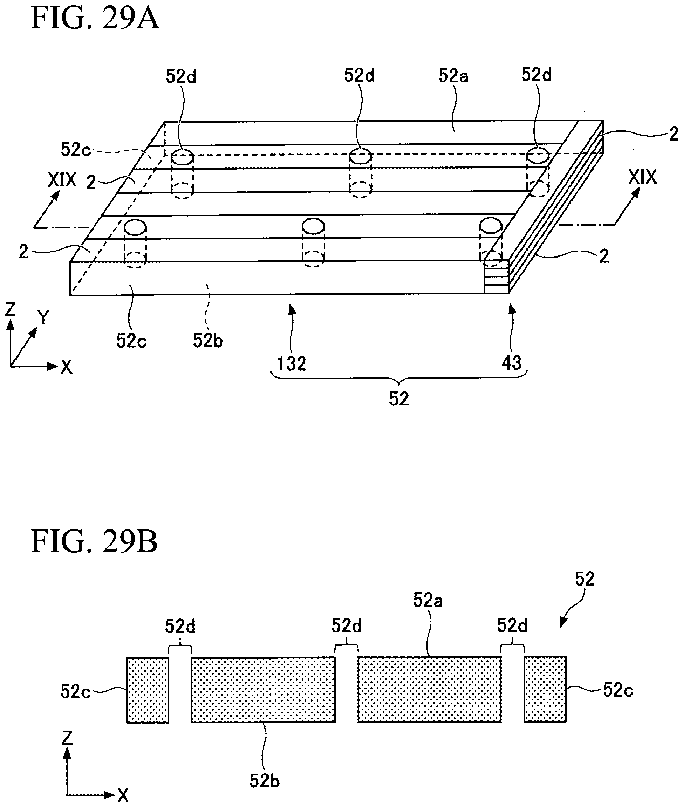

FIG. 29A is a perspective view showing the structure of the plate of the present modification example. FIG. 29B is a cross-sectional view taken along the line XIX-XIX of the structure.

As shown in FIG. 29A and FIG. 29B, a plate 52 includes a heat transfer member 132 instead of the heat transfer member 101. The heat transfer member 132 has the same structure as the plate 32. That is, the heat transfer member 132 is a thin plate-like XZ heat transfer member which is formed of the laminate of the graphenes 2 and is provided with through holes 52d that extend from a top surface 52a to a bottom surface 52b.

As a tray, as in the modification example of the second embodiment, the tray 33 shown in FIG. 18A and FIG. 18B is used. The plate 52 and the tray 33 are prepared, and then the plate 52 is accommodated in the tray 33.

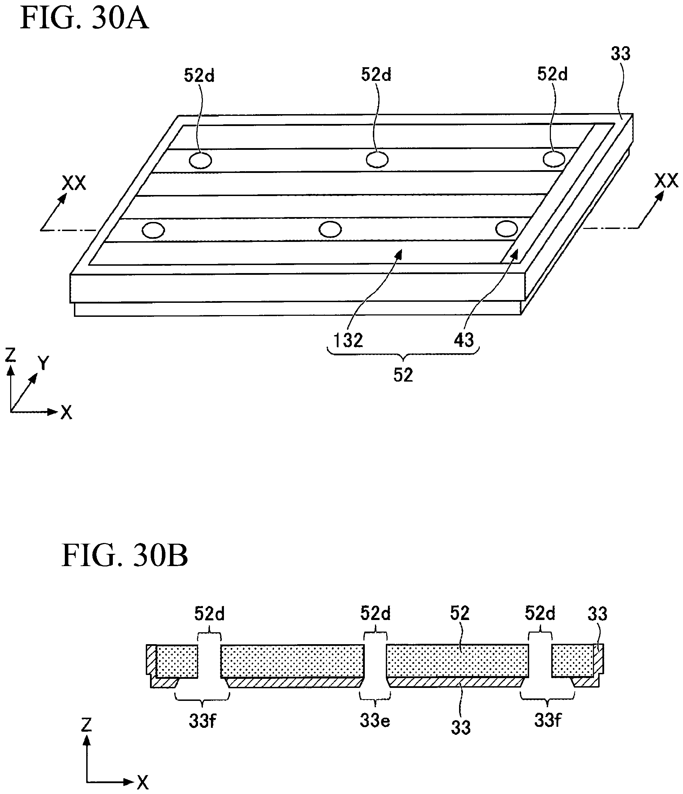

FIG. 30A is a perspective view showing a structure in a state where the plate 52 is accommodated in the tray 33. FIG. 30B is a cross-sectional view taken along the line XX-XX of the structure.

As shown in FIG. 30A and FIG. 30B, the plate 52 is accommodated in the tray 33 such that the bottom surface 52b among the surfaces of the plate 52 contacts the inner bottom surface 33c of the tray 33 (see FIG. 18A and FIG. 18B).

As a result, the bottom surface 52b and the lateral surfaces 52c of the plate 52 are covered with the tray 33, and only the top surface 52a of the plate 52 is exposed.

Among the through holes 52d of the plate 52, two through holes 52d at the center communicate with two first openings 33e at the center of the tray 33 along the thickness direction (Z direction) of the plate 52.

Two through holes 52d at the left end communicate with the second opening 33f, which is larger than the through holes 52d and positioned at the left end of the tray 33, along the Z direction. Furthermore, two through holes 52d at the right end communicate with the second opening 33f, which is larger than the through holes 52d and positioned at the right end of the tray 33, along the Z direction.

For the plate 52 and the tray 33 that are in a state where the plate 52 is accommodated in the tray 33, by performing the steps in the second embodiment shown in FIG. 11A to FIG. 12 and then removing the fixing tools, residues, and the like, a structure of a composite heat transfer member according to the present modification example is obtained.

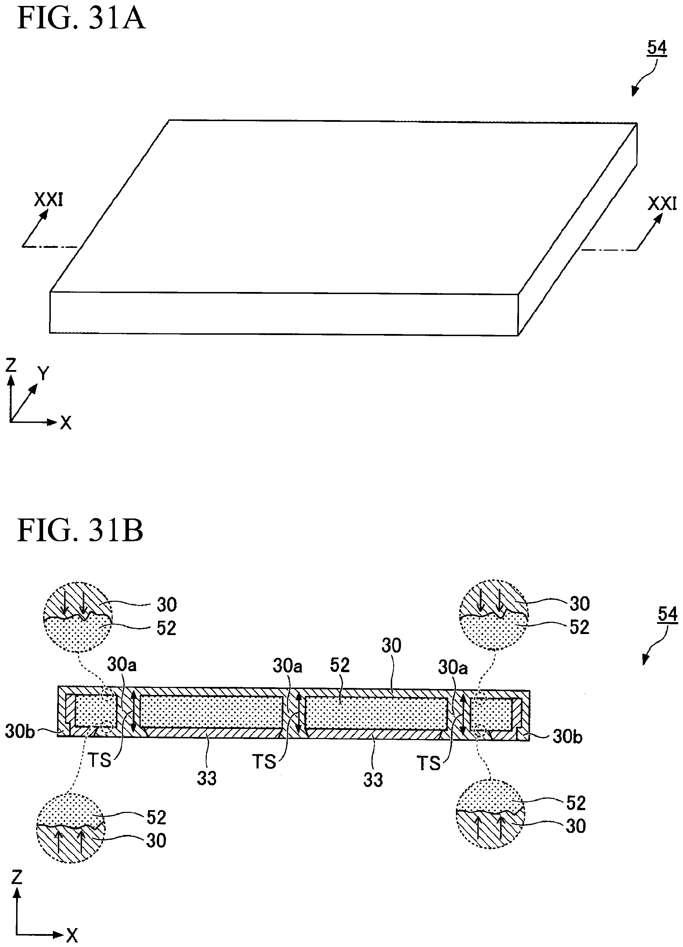

FIG. 31A is a perspective view showing the structure of the composite heat transfer member. FIG. 31B is a cross-sectional view taken along the line XXI-XXI of the structure.

As shown in FIG. 31A and FIG. 31B, a composite heat transfer member 54 according to the present modification example includes the plate 52, which is the laminate of the graphenes 2, as a heat transfer member on one side, the tray 33 of a magnesium alloy, which covers the surfaces of the plate 52 except for the top surface 52a, as a heat transfer member on the other side, and the cast-molded article 30 of a magnesium alloy which covers the top surface 52a of the plate 52.

According to the present modification example, a portion 30a of the cast-molded article 30 fills up the through holes 52d of the plate 52 and the openings 33e and 33f of the tray 33.

As a result, through the portion 30a, the cast-molded article 30 covering the top surface 52a of the plate 52 is connected to the cast-molded article 30 covering the bottom surface 52b.

As in the modification example of the second embodiment, due to the difference in shrinkage that is caused between the cast-molded article 30 and the plate 52 at the time of forming the cast-molded article 30, even after the composite heat transfer member 54 is produced, residual tensile stress TS exists in the cast-molded article 30 as being indicated by the arrows.

In a case where the composite heat transfer member is used in a high-temperature environment, the residual tensile stress TS is not lost. Therefore, the cast-molded article 30 remains pressed on the top surface 52a of the plate 52 as being indicated by the arrows in the circles of broken lines.

The second openings 33f of the tray 33 are larger than the through holes 52d of the plate 52 that communicate with the second openings 33f.

Accordingly, by the portion 30a of the cast-molded article 30 that fills up the second openings 33f, the cast-molded article 30 can also remain pressed on the bottom surface 52b of the plate 52 as being indicated by the arrows in the circles of broken lines.

As a result, further improved thermal conductivity can be maintained between the cast-molded article 30 and the plate 52.

In addition, according to the present modification example, as in the modification example of the second embodiment, the projection 30b of the cast-molded article 30 is fitted with the depression 33b of outer lateral surfaces 33a of the tray 33. Furthermore, the portion 30a of the cast-molded article 30 is fitted with the tapered first openings 33e and the tapered second openings 33f at the bottom of the tray 33.

Consequently, it is possible to more reliably inhibit the cast-molded article 30 from being detached from the tray 33.

### (Sixth embodiment)

In the fourth embodiment and the fifth embodiment, as a composite heat transfer member, a heat spreader was produced. However, in the present embodiment, as in the third embodiment, as a composite heat transfer member, a heat spreader that also functions as a heat sink will be produced.

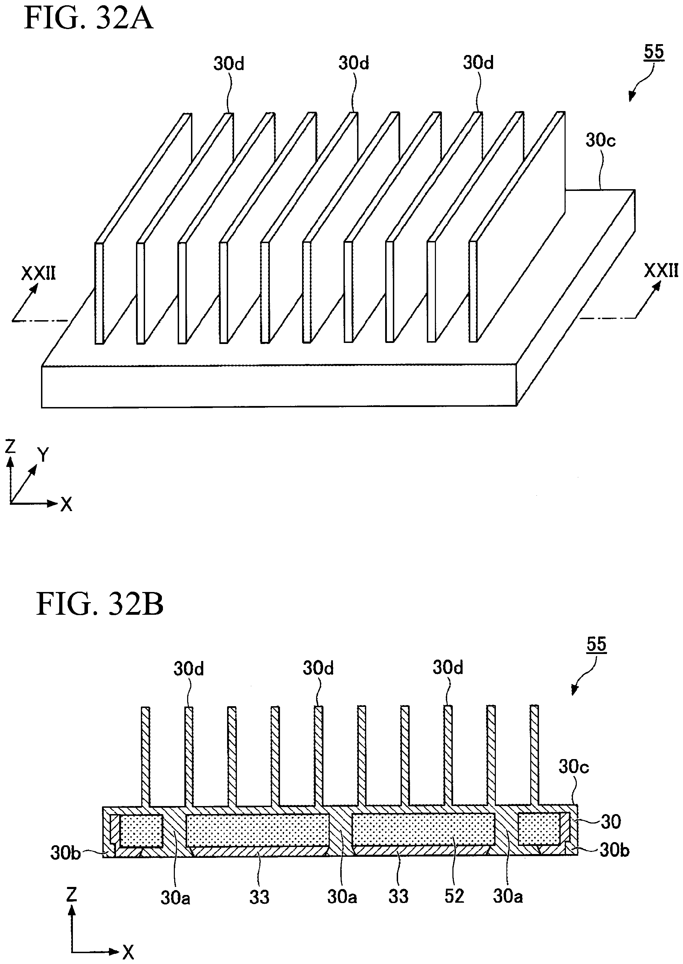

FIG. 32A is a perspective view showing the structure of the composite heat transfer member. FIG. 32B is a cross-sectional view taken along the line XXII-XXII of the structure. In FIG. 32A and FIG. 32B, the same elements as those in the fifth embodiment will be marked with the same reference signs as those in the fifth embodiment and will not be described in the following section.

As shown in FIG. 32A and FIG. 32B, basically, a composite heat transfer member 55 according to the present embodiment has the same structure as the structure of the composite heat transfer member 54 according to the modification example of the fifth embodiment.

That is, the composite heat transfer member 55 also includes the plate 52, which is the laminate of the graphenes 2, as a heat transfer member on one side, the tray 33 of a magnesium alloy, which covers the surfaces of the plate 52 except for the top surface 52a, as a heat transfer member on the other side, and the cast-molded article 30 of a magnesium alloy which covers the top surface 52a of the plate 52.

In the composite heat transfer member 55, as in the third embodiment, a plurality of fins 30d are provided on the outer top surface 30c of the cast-molded article 30.

In a case where a movable mold for forming the fins 30d is used instead of the movable mold 27 used in the second embodiment, the composite heat transfer member 55 having the structure described above can be obtained by performing the same steps as the steps in the second embodiment shown in FIG. 11A to FIG. 12.

In this way, according to the present embodiment, the fins 30d are provided on the cast-molded article 30.

Therefore, by the composite heat transfer member 55, the heat generated from electronic components or electronic instruments can be moved and dissipated from the fins 30d.

The cast-molded article 30 and the fins 30d are integrated. Accordingly, in this case, thermal resistance can be further reduced than in a case where a cast-molded article and fins are separately provided, because a thermally conductive member or a thermally conductive adhesive for bonding the cast-molded article to the fins is not used.

The composite heat transfer member 55 according to the present embodiment has a structure that is basically the same as the structure of the composite heat transfer member 54 according to the modification example of the fifth embodiment. However, the composite heat transfer member 55 is not limited to the structure.

For example, the composite heat transfer member according to the present embodiment may have a structure that is basically the same as the structure of the composite heat transfer member 49 according to the fourth embodiment. In this case, a plurality of fins may be provided on the outer top surface of the cast-molded article 8. The composite heat transfer member according to the present embodiment may have a structure that is basically the same as the structure of the composite heat transfer member 51 according to the fifth embodiment.

### (Seventh embodiment)

In the present embodiment, a tray having a shape different from the shape of the tray in the fifth embodiment will be used.

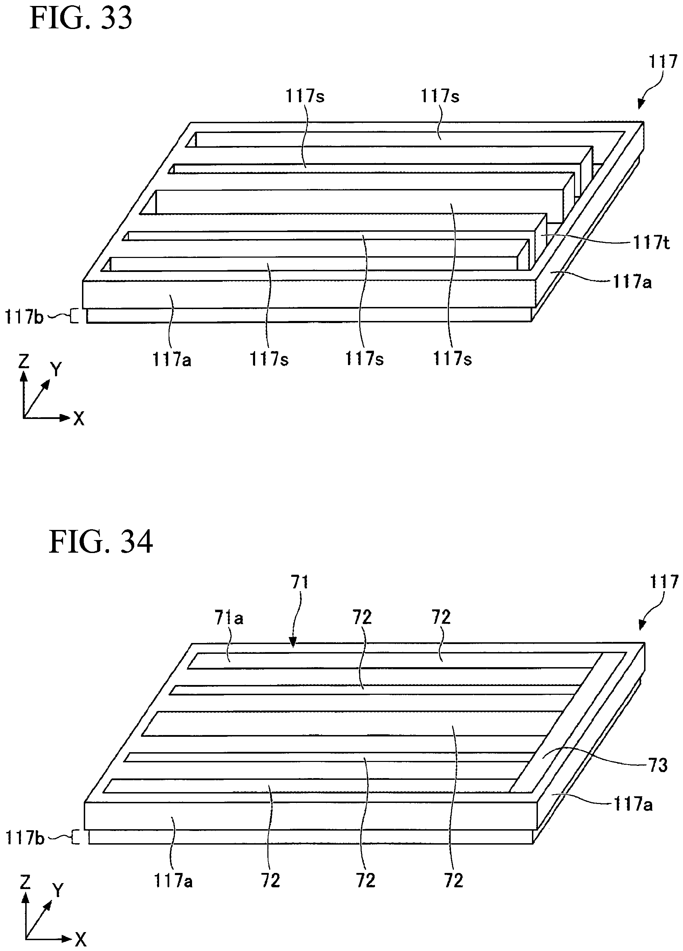

FIG. 33 is a perspective view showing the structure of the tray of the seventh embodiment.

A tray 117 used in the seventh embodiment is a metal container just as the tray 17. As in the tray 17, a depression 117b is provided on the lower side of outer lateral surfaces 117a of the tray 117. Furthermore, on the top surface of the tray 117, five grooves 117s for an XZ heat transfer member and a groove 117t for an XY heat transfer member are formed. One end of each of the grooves 117s is connected to the groove 117t. The tray 117 can be prepared by the same method as that used for preparing the tray 17 by using the same material as the material of the tray 17.

XZ heat transfer members 72 to be accommodated in the grooves 117s and an XY heat transfer member 73 to be accommodated in the groove 117t are prepared. The XZ heat transfer members 72 and the XY heat transfer member 73 can be prepared, for example, by the same method as that used for preparing the plate 1 or 13.

FIG. 34 is a perspective view showing a structure in a state where the XZ heat transfer members 72 and the XY heat transfer member 73 are accommodated in the tray 117.

The XZ heat transfer members 72 are accommodated in the grooves 117s such that the bottom surface among the surfaces of each of the XZ heat transfer members 72 contacts the inner bottom surface of the tray 117. The XY heat transfer member 73 is accommodated in the groove 117t such that the bottom surface among the surfaces of the XY heat transfer member 73 contacts the inner bottom surface of the tray 117. One lateral surface of each of the XZ heat transfer members 72 in the X direction contacts a lateral surface of the XY heat transfer member 73 in the X direction, and one end of each of the XZ heat transfer members 72 in the X direction is connected to the XY heat transfer member 73. A plate 71 is constituted with the XZ heat transfer members 72 and the XY heat transfer member 73.

In the seventh embodiment, the bottom surface and the lateral surfaces of the plate 71 are covered with the tray 117, and only a top surface 71a of the plate 71 is exposed.

For the plate 71 and the tray 117 that are in a state where the plate 71 is accommodated in the tray 117, by performing the steps in the second embodiment shown in FIG. 11A to FIG. 12 and then removing the fixing tools, residues, and the like, a structure of a composite heat transfer member according to the present embodiment is obtained.

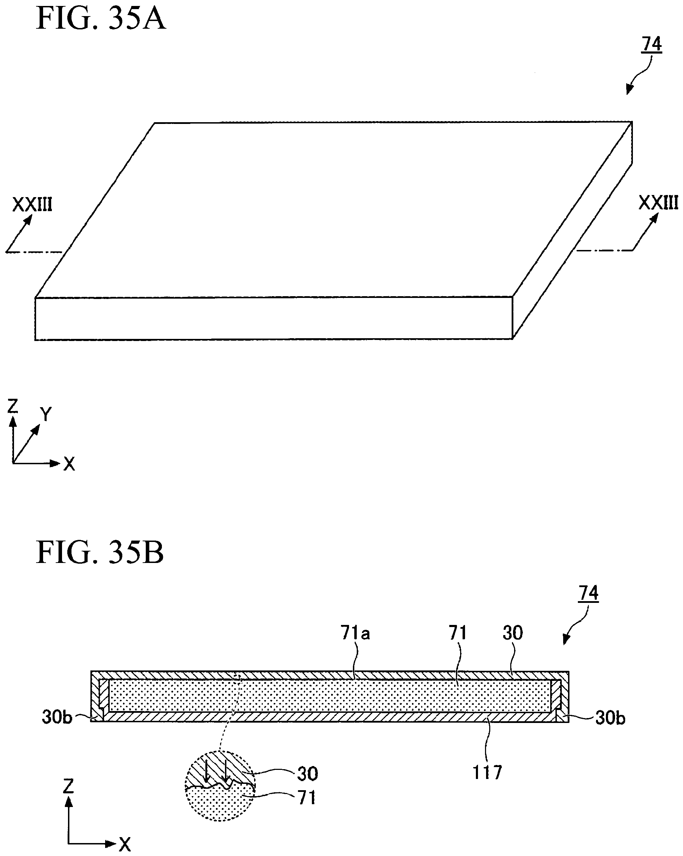

FIG. 35A is a perspective view showing the structure of the composite heat transfer member. FIG. 35B is a cross-sectional view taken along the line XXIII-XXIII of the structure.

As shown in FIG. 35A and FIG. 35B, a composite heat transfer member 74 according to the present embodiment includes the plate 71, which is the laminate of the graphenes 2, as a heat transfer member on one side, the tray 117 of a magnesium alloy, which covers the surfaces of the plate 71 except for the top surface 71a, as a heat transfer member on the other side, and the cast-molded article 30 of a magnesium alloy which covers the top surface 71a of the plate 71.

According to the present embodiment, it is possible to obtain the same effect as the effect of the fifth embodiment. For example, due to the difference in shrinkage that is caused between the cast-molded article 30 and the plate 71 at the time of forming the cast-molded article 30, even after the composite heat transfer member 74 is produced, residual tensile stress exists in the cast-molded article 30 while residual compressive stress exists in the plate 71. In a case where the composite heat transfer member 74 is used in a high-temperature environment, the residual stresses are not lost. Therefore, the cast-molded article 30 remains pressed on the top surface 71a of the plate 71 as being indicated by the arrows in the circles of broken lines in FIG. 35B. Accordingly, the excellent thermal conductivity between the cast-molded article 30 and the plate 71 can be maintained.

Furthermore, by the combination of the XZ heat transfer members 72 and the XY heat transfer member 73, it is possible to obtain excellent thermal conductivity substantially in all directions in the X-Y plane.

In addition, because the magnesium alloy is lighter than graphene, the overall weight can be reduced. Moreover, the use of the magnesium alloy is effective for reducing the material cost.

In the seventh embodiment, the XZ heat transfer members 72 and the XY heat transfer member 73 are accommodated in the tray 117. However, a plurality of heat transfer members of one kind may be accommodated in one tray. For example, in a case where a plurality of heat sources are included in an electronic component or an electronic instrument, XZ heat transfer members may be accommodated in the tray at sites corresponding to the heat sources. In this case, other XZ heat transfer members may be accommodated in the tray such that heat can be transferred to the vicinity of the outer lateral surfaces of the tray.

### (Modification example)

In the present modification example, a tray having a shape different from the shape of the tray of the seventh embodiment will be used.

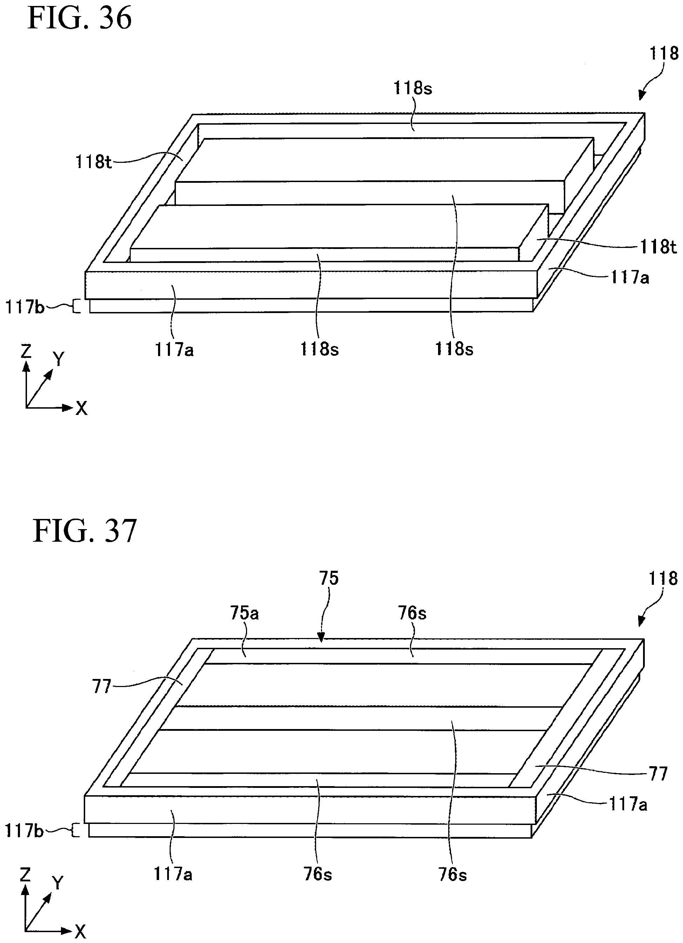

FIG. 36 is a perspective view showing the structure of the tray of the present modification example.

A tray 118 used in the present modification example is a metal container just as the tray 17. As in the tray 17, a depression 117b is provided on the lower side of outer lateral surfaces 117a of the tray 118. Furthermore, on the top surface of the tray 118, three grooves 118s for an XZ heat transfer member and two grooves 118t for an XY heat transfer member are formed. Both ends of each of the grooves 118s are connected to both the grooves 118t. The tray 118 can be prepared by the same method as that used for preparing the tray 17 by using the same material as the material of the tray 17.

An XZ heat transfer member 76 to be accommodated in the grooves 118s and an XY heat transfer member 77 to be accommodated in the grooves 118t are prepared. The XZ heat transfer member 76 and the XY heat transfer member 77 can be prepared, for example, by the same method as that used for preparing the plate 1 or 13.

FIG. 37 is a perspective view showing a structure in a state where the XZ heat transfer member 76 and the XY heat transfer member 77 are accommodated in the tray 118.

The XZ heat transfer member 76 is accommodated in the grooves 118s such that the bottom surface among the surfaces of the XZ heat transfer member 76 contacts the inner bottom surface of the tray 118. The XY heat transfer member 77 is accommodated in the grooves 118t such that the bottom surface among the surfaces of the XY heat transfer member 77 contacts the inner bottom surface of the tray 118. Furthermore, lateral surfaces of the XY heat transfer member 77 in the X direction contact both the lateral surfaces of each of the XZ heat transfer members 76 in the X direction, and both ends of each of the XZ heat transfer members 76 in the X direction are connected to the XY heat transfer member 77. A plate 75 is constituted with the XZ heat transfer members 76 and the XY heat transfer members 77.

In the present modification example, the bottom surface and the lateral surfaces of the plate 75 are covered with the tray 118, and only a top surface 75a of the plate 75 is exposed.

For the plate 75 and the tray 118 that are in a state where the plate 75 is accommodated in the tray 118, by performing the steps in the second embodiment shown in FIG. 11A to FIG. 12 and then removing the fixing tools, residues, and the like, a structure of a composite heat transfer member according to the present modification example is obtained.

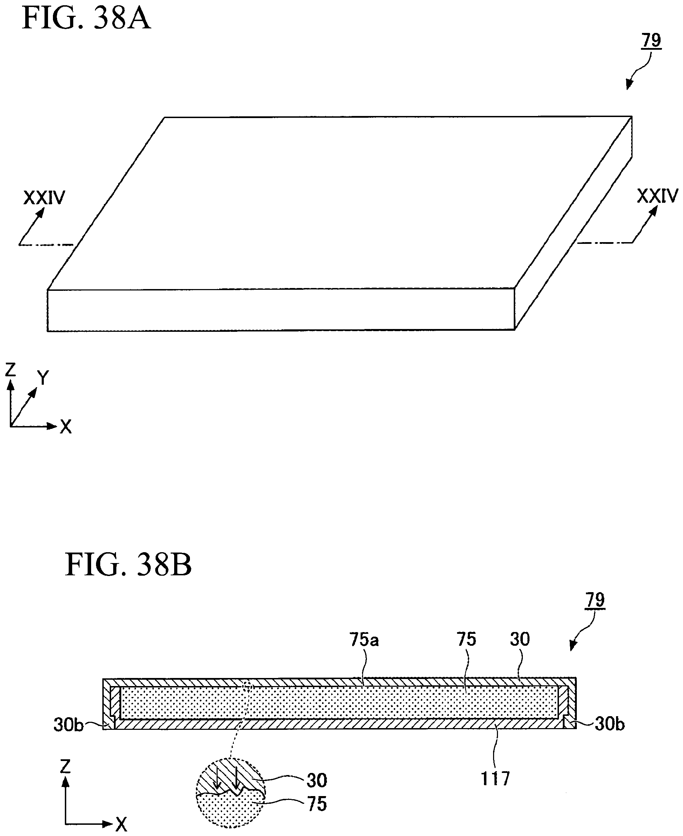

FIG. 38A is a perspective view showing the structure of the composite heat transfer member. FIG. 38B is a cross-sectional view taken along the line XXIV-XXIV of the structure.

As show in FIG. 38A and FIG. 38B, a composite heat transfer member 79 according to the present modification example includes the plate 75, which is the laminate of the graphenes 2, as a heat transfer member on one side, the tray 118 of a magnesium alloy, which covers the surfaces of the plate 75 except for the top surface 75a, as a heat transfer member on the other side, and the cast-molded article 30 of a magnesium alloy which covers the top surface 75a of the plate 75.

Accordingly, by the present modification example, the same effect as the effect of the seventh embodiment can also be obtained.

At the time of using the composite heat transfer member 74 according to the seventh embodiment, it is preferable that a heat source is positioned in the vicinity of a site where the XZ heat transfer member 72 and the XY heat transfer member 73 positioned at the center in the Y direction are connected to each other. In contrast, at the time of using the composite heat transfer member 79 according to the modification example, it is preferable that a heat source is positioned at the center of the XZ heat transfer member 76, which is positioned at the center in the Y direction, in the X direction. In a case where the heat source is positioned in the vicinity of the XZ heat transfer member 72 or 76, heat can be transferred with high efficiency.

Furthermore, in order to obtain higher heat dissipation efficiency, it is preferable that fins are provided on five XZ heat transfer members 72 in the composite heat transfer member 74 and on three XZ heat transfer members 76 in the composite heat transfer member 79 such that the composite heat transfer members also function as a heat sink.

### (Eighth embodiment)

In the present embodiment, as a composite heat transfer member, a heat spreader that also functions as a heat sink will be produced.

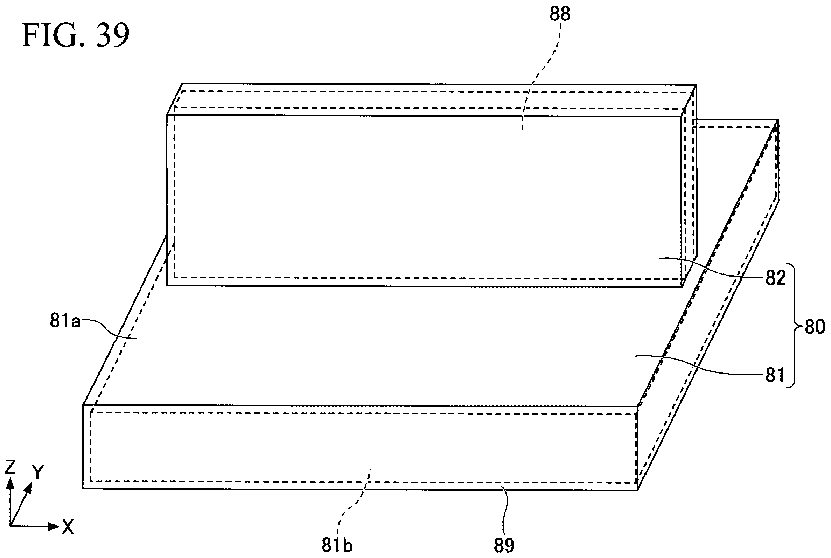

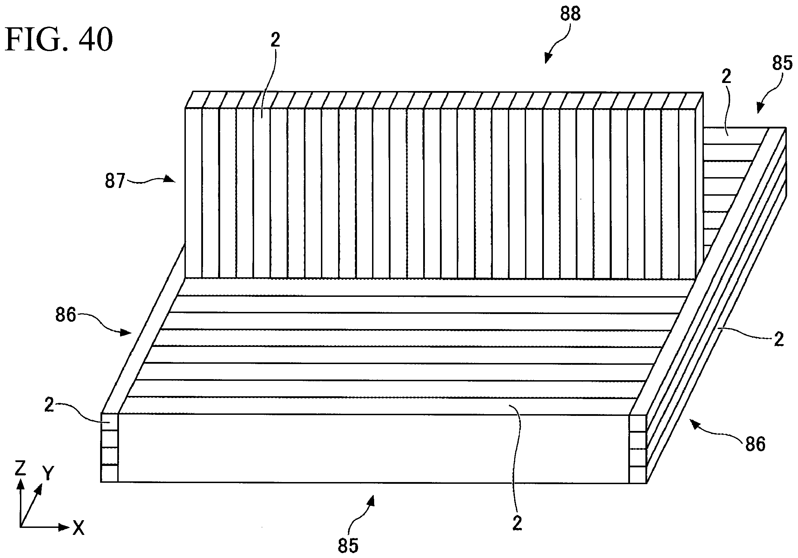

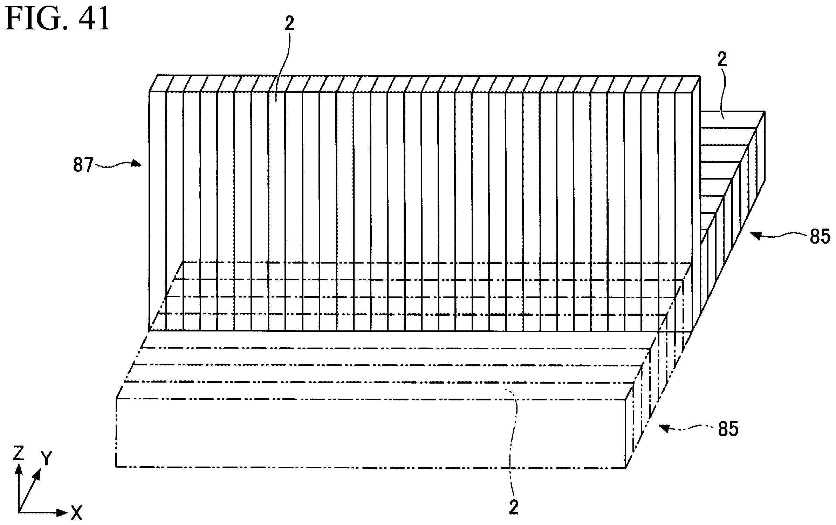

FIG. 39 is a perspective view showing a composite heat transfer member according to an eighth embodiment. FIG. 40 is a perspective view showing the constitution of a plate included in the composite heat transfer member according to the eighth embodiment. FIG. 41 is a perspective view showing the constitution of a portion of the plate included in the composite heat transfer member according to the eighth embodiment.

As shown in FIG. 39, a composite heat transfer member 80 according to the eighth embodiment has a plate-like base portion 81 and a fin 82 erecting on the base portion 81. For example, the base portion 81 has a top surface 81a and a bottom surface 81b that are parallel to the X-Y plane, and the fin 82 extends along the Z direction from the top surface 81a. A heat source contacts the bottom surface 81b. The composite heat transfer member 80 includes a plate 88, which is the laminate of the graphenes 2, as a heat transfer member on one side, and a cast-molded article 89 of a magnesium alloy, which covers the surfaces of the plate 88, as a heat transfer member on the other side. The plate 88 and the cast-molded article 89 are constituted such that these are in tight contact with each other by the same method as the method in the first embodiment, the second embodiment, or the like.

As shown in FIG. 40 and FIG. 41, the plate 88 includes an XZ heat transfer member 85, XY heat transfer members 86, and an YZ heat transfer member 87. The XZ heat transfer member 85 is constituted with the graphenes 2 laminated in the Y direction. Each of the XY heat transfer members 86 is constituted with the graphenes 2 laminated in the Z direction. The YZ heat transfer member 87 is constituted with the graphenes 2 laminated in the X direction.

A lateral surface of each of the XY heat transfer members 86 contacts each of both the lateral surfaces of the XZ heat transfer member 85 in the X direction, and the XY heat transfer members 86 are connected to the XZ heat transfer member 85. The dimension (height) of the XZ heat transfer member 85 in the Z direction is approximately the same as the dimension (height) of each of the XY heat transfer members 86 in the Z direction, and the XZ heat transfer member 85 and the XY heat transfer members 86 are included in the base portion 81.

A portion of a lateral surface of the YZ heat transfer member 87 in the Y direction contacts a lateral surface of the XZ heat transfer member 85 in the Y direction, and the YZ heat transfer member 87 is connected to the XZ heat transfer member 85. The dimension of the XZ heat transfer member 85 in the X direction is approximately the same as the dimension of the YZ heat transfer member 87 in the X direction. The portion of the YZ heat transfer member 87 that contacts the XZ heat transfer member 85 is included in the base portion 81, and a portion that protrudes in the Z direction from the aforementioned portion is included in the fin 82.

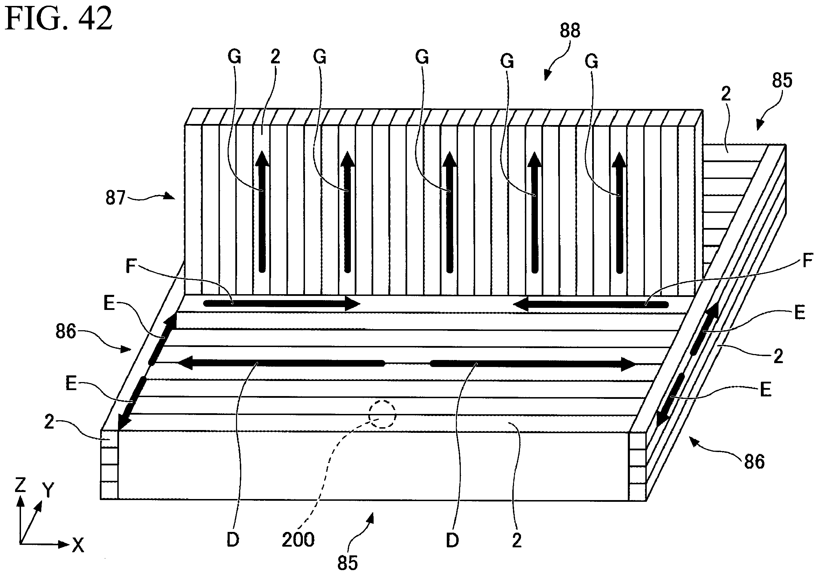

The heat transfer pathway in the composite heat transfer member 80 will be described. FIG. 42 is a view showing an example of the heat transfer pathway in the plate 88 of the eighth embodiment. Herein, a heat source 200 is assumed to be at the center of the bottom surface side of the XZ heat transfer member 85.

First, the heat generated from the heat source 200 is transferred along the Z direction through graphene, which is positioned in the vicinity of the center in the Y direction among the graphenes 2 constituting the XZ heat transfer member 85, and transferred along the X direction as well (arrow D). Thereafter, the heat is transferred to the XY heat transfer members 86 at the end of the XZ heat transfer member 85 in the X direction. The heat is then transferred along the X direction through the XY heat transfer members 86 and transferred along the Y direction as well (arrow E). A portion of the heat transferred through the XY heat transfer members 86 is transferred to a portion of the XZ heat transfer member 85. The heat is then transferred along the Z direction through the XZ heat transfer member 85 and transferred along the X direction as well (arrow F). Furthermore, the heat transferred through graphene contacting the YZ heat transfer member 87 among the graphenes 2 constituting the XZ heat transfer member 85 is transferred to the YZ heat transfer member 87. The heat is then transferred along the Y direction through the YZ heat transfer member 87 and transferred along the Z direction as well (arrow G). Because the plate 88 and the cast-molded article 89 are in tight contact with each other, the heat is released out of the cast-molded article 89.

### (Ninth embodiment)

The present embodiment relates to a composite heat transfer member which is a heat spreader that functions as a heat sink as well.

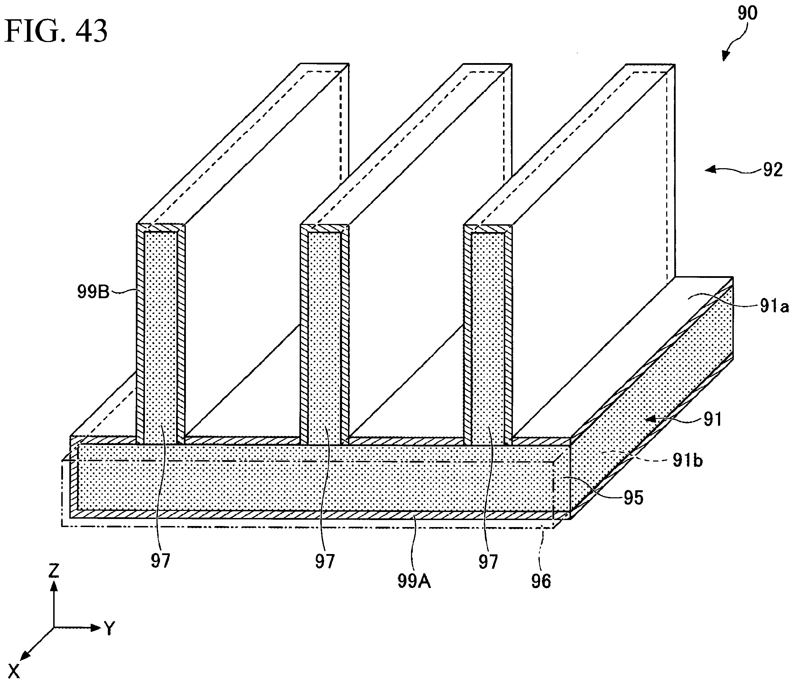

FIG. 43 is a partial cross-sectional view showing a composite heat transfer member according to a ninth embodiment.

As shown in FIG. 43, a composite heat transfer member 90 according to the ninth embodiment has a plate-like base portion 91 and fins 92 erecting on the base portion 91. For example, the base portion 91 has a top surface 91a and a bottom surface 91b that are parallel to the X-Y plane, and the fins 92 extend in the Z direction from the top surface 91a. A heat source contacts the bottom surface 91b. The base portion 91 has an XZ heat transfer member 95, which is constituted with graphenes laminated in the Y direction, and an XY heat transfer member 96 which is constituted with graphenes laminated in the Z direction. Each of the fins 92 has an YZ heat transfer member 97 which is constituted with graphenes laminated in the X direction. The YZ heat transfer member 97 contacts the XZ heat transfer member 95 and erects on the XZ heat transfer member 95 along the Z direction. The composite heat transfer member 90 has a cast-molded article 99B of a magnesium alloy, which covers the surfaces of each of the YZ heat transfer members 97, and a cast-molded article 99A of a magnesium alloy which covers the surfaces of the XZ heat transfer member 95 and the XY heat transfer member 96. The XZ heat transfer member 95, the XY heat transfer member 96, the YZ heat transfer members 97, and the cast-molded articles 99A and 99B are constituted such that these are in tight contact with each other by the same method as the method in the first embodiment, the second embodiment, or the like.

In the ninth embodiment constituted as above, as in the eighth embodiment, the heat from the heat source mounted on the bottom surface 91b is released out of the cast-molded articles 99A and 99B through the XZ heat transfer member 95, the XY heat transfer member 96, and the YZ heat transfer members 97.

### (First modification example)

The present modification example is different from the ninth embodiment in terms of the constitution of the cast-molded article 99B.

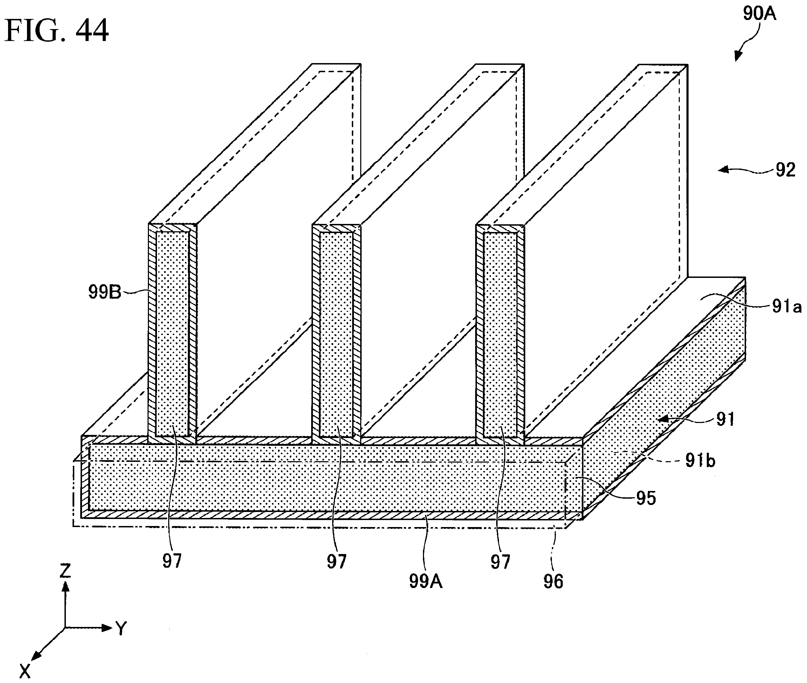

FIG. 44 is a partial cross-sectional view showing a composite heat transfer member according to a first modification example of the ninth embodiment.

As shown in FIG. 44, in a composite heat transfer member 90A according to the present modification example, the cast-molded article 99B also covers the surface of each of the YZ heat transfer members 97 that contacts the XZ heat transfer member 95, and the YZ heat transfer members 97 erect on the XZ heat transfer member 95 along the Z direction in a state where a portion of the cast-molded article 99B is interposed between each of the YZ heat transfer members 97 and the XZ heat transfer member 95. Other constitutions are the same as the constitutions of the ninth embodiment.

In the first modification example constituted as above, as in the ninth embodiment, the heat from the heat source mounted on the bottom surface 91b is released out of the cast-molded articles 99A and 99B through the XZ heat transfer member 95, the XY heat transfer member 96, and the YZ heat transfer members 97.

### (Second modification example)

The present modification example is different from the ninth embodiment in terms of the constitutions of the YZ heat transfer members 97 and the cast-molded article 99B.

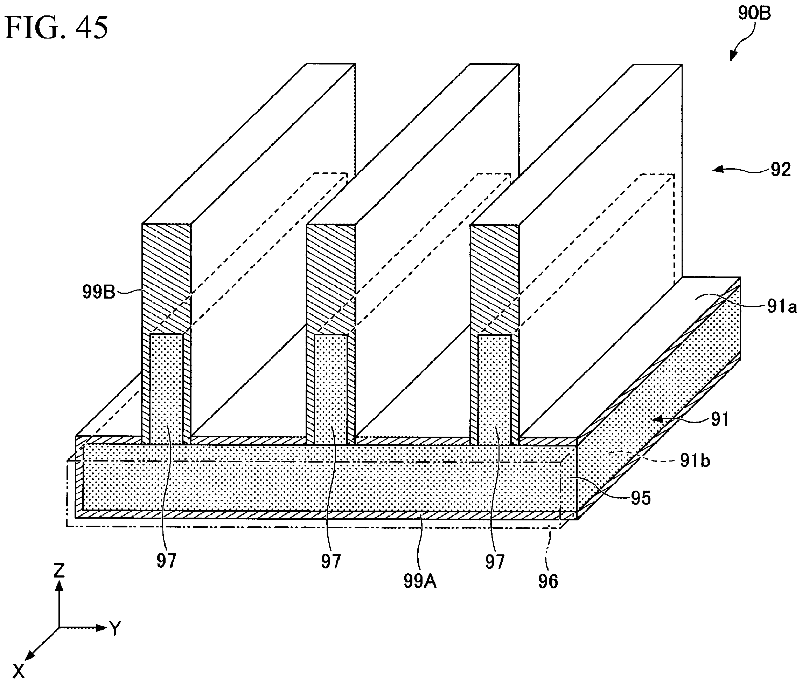

FIG. 45 is a partial cross-sectional view showing a composite heat transfer member according to a second modification example of the ninth embodiment.

As shown in FIG. 45, in a composite heat transfer member 90B according to the present modification example, the dimension of each of the YZ heat transfer members 97 in the Z direction is smaller than the dimension in the ninth embodiment. Other constitutions are the same as the constitutions in the ninth embodiment.

In the second modification example constituted as above, as in the ninth embodiment, the heat from the heat source mounted on the bottom surface 91b is released out of the cast-molded articles 99A and 99B through the XZ heat transfer member 95, the XY heat transfer member 96, and the YZ heat transfer members 97.

In the first modification example, as in the second modification example, the dimension of each of the YZ heat transfer members 97 in the Z direction may be smaller than the dimension in the ninth embodiment.

### (Third modification example)

The present modification example is different from the ninth embodiment in terms of the constitution of the cast-molded article 99A.

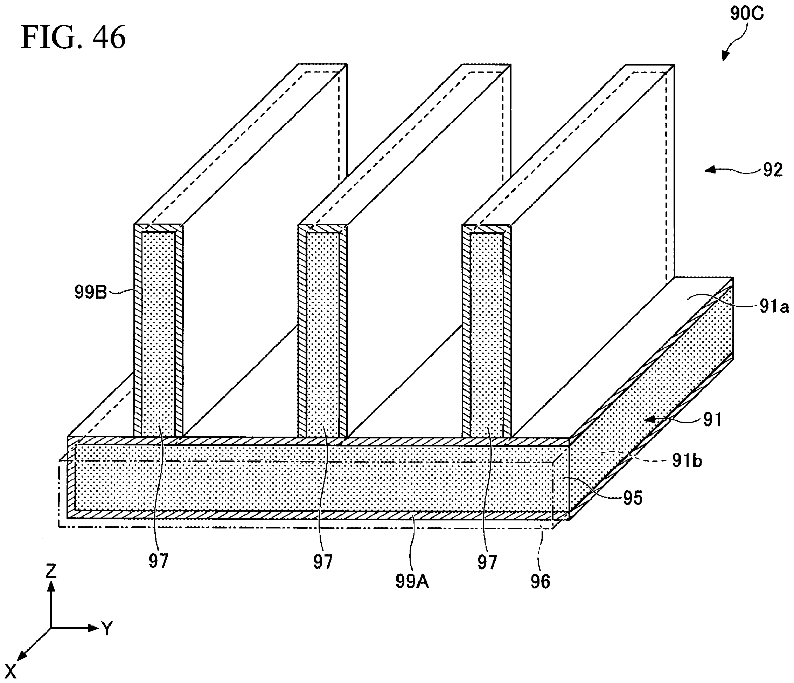

FIG. 46 is a partial cross-sectional view showing a composite heat transfer member according to a third modification example of the ninth embodiment.

As shown in FIG. 46, in a composite heat transfer member 90C according to the present modification example, the cast-molded article 99A covers the surface of the XZ heat transfer member 95 that contacts the YZ heat transfer members 97, and the YZ heat transfer members 97 erect on the XZ heat transfer member 95 along the Z direction in a state where a portion of the cast-molded article 99A is interposed between each of the YZ heat transfer members 97 and the XZ heat transfer member 95. Other constitutions are the same as the constitutions in the ninth embodiment.

In the third modification example constituted as above, as in the ninth embodiment, the heat from the heat source mounted on the bottom surface 91b is released out of the cast-molded articles 99A and 99B through the XZ heat transfer member 95, the XY heat transfer member 96, and the YZ heat transfer members 97.

### (Tenth embodiment)

The present embodiment relates to a composite heat transfer member suited for a specific heat source.

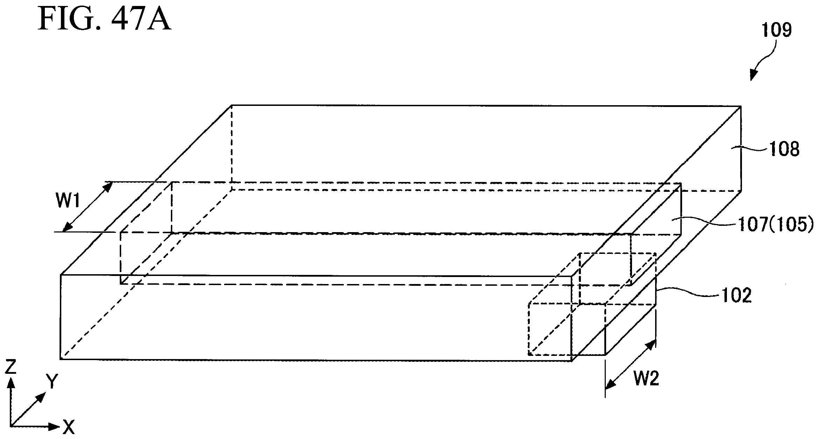

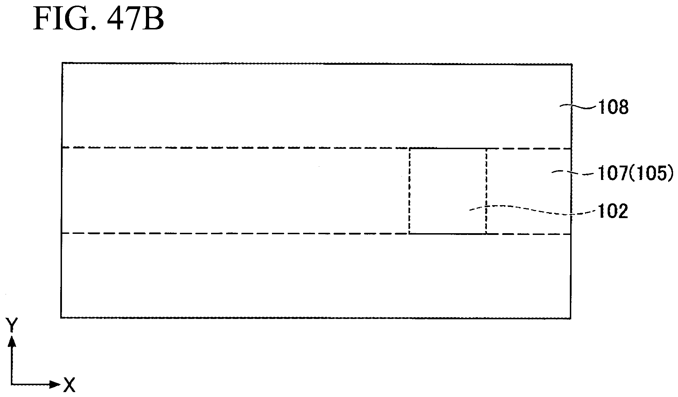

FIG. 47A is a perspective view showing the structure of a composite heat transfer member according to a tenth embodiment. FIG. 47B is a top view of the structure.

A composite heat transfer member 109 according to the tenth embodiment has a carbon plate 107 and a cast-molded article 108 of a magnesium alloy covering the surfaces of the plate 107. The plate 107 has an XZ heat transfer member 105 constituted with graphenes laminated in the Y direction perpendicular to the thickness direction (Z direction) of the plate 107.

The composite heat transfer member 109 is used by being mounted on a heat source 102 whose dimension in the Y direction is W2. Furthermore, the dimension of the XZ heat transfer member 105 in the Y direction is W1. In the present embodiment, the dimension W1 is identical to the dimension W2.

In the tenth embodiment, as shown in FIG. 47A and FIG. 47B, the composite heat transfer member 109 is mounted such that the heat source 102 overlaps the XZ heat transfer member 105 along the Y direction when seen in a plan view. Accordingly, the heat generated from the heat source 102 is transferred along the X direction and the Y direction by the XZ heat transfer member 105 with high efficiency and released to the outside.

In the XZ heat transfer member 105, the heat transfer performance in the Y direction (lamination direction) is lower than the heat transfer performance in the X direction and the Z direction. Therefore, even though the XZ heat transfer member 105 is provided to cover a wider range in the Y direction, the heat transfer performance remains substantially the same. Generally, a magnesium alloy is less expensive than graphene. Therefore, in a case where substantially the same heat transfer performance is obtained, a composite heat transfer member in which a small amount of graphene is used is preferable.

"Identical" mentioned herein does not means that the dimensions are identical in a strict sense, and may mean dimensions that can be regarded as being "identical" according to common sense. Even though the dimensions are not identical in a strict sense, the heat generated from the heat source can be released to the outside with high efficiency. For example, the width W1 is preferably 100% to 110% of the width W2, and more preferably 100% to 105% of the width W2.

### (Application examples of composite heat transfer member)

The composite heat transfer members according to the first embodiment to the tenth embodiment described above can be applied to various components involved in heat transfer.

For example, the first embodiment, the second embodiment, the fourth embodiment, the fifth embodiment, the seventh embodiment, and the tenth embodiment which are heat spreaders or the composite heat transfer members 9, 16, 31, 34, 49, 46, 51, 54, 74, 79, and 109 according to modification examples of the above embodiments can be applied to water cooling jacket and cooling water piping made of copper for heating components such as Central Processing Unit (CPU) of a server or applied to a base substrate for a power module.

Furthermore, the third embodiment, the sixth embodiment, the eighth embodiment, and the ninth embodiment which are heat spreaders that also function as heat sinks or the composite heat transfer members 35, 55, 80, 90, 90A, 90B, and 90C according to modification examples of the above embodiments can be applied to a heat sink of an LED headlamps for automobiles made of aluminum or applied to a heat sink for a mobile base station.

The present application claims priorities based on Japanese Patent Application No. 2017-222862 filed to Japanese Patent Office on November 20, 2017 and Japanese Patent Application No. 2018-131470 filed to Japanese Patent Office on July 11, 2018, the entire content of which is incorporated into the present specification.

### Reference Signs List

1, 13, 15, 32, 41, 44, 52, 71, 75, 88, 107 ... plate, 1a, 15a, 32a, 41a, 44a, 52a, 71a, 75a ... top surface of plate, 1b, 15b, 32b, 41b, 44b, 52b ... bottom surface of plate, 1c, 13c, 15c, 41c, 44c, 52c ··· lateral surface of plate, 2 ··· graphene, 4 ··· casting mold, 4b ··· lower portion of casting mold, 4a ··· upper portion of casting mold, 6 ··· cavity of casting mold, 7, 29 ··· molten metal, 8, 30, 99A, 99B, 108 ··· cast-molded article, 8a, 30a ··· a portion of cast-molded article, 9, 14, 16, 31, 34, 35, 46, 49, 51, 54, 55, 74, 79, 80, 90, 90A, 90B, 90C, 109 ··· composite heat transfer member, 15d, 32d, 44d, 52d ··· through hole of plate, 17, 33, 117, 118 ··· tray, 17a, 33a, 117a ··· outer lateral surface of tray, 17b, 33b, 117b ··· depression of tray, 17c, 33c ··· inner bottom surface of tray, 17d, 33d ··· outer bottom surface of tray, 18 ··· casting device, 25 ··· immovable mold, 25a ··· surface of immovable mold, 27 ··· movable mold, 28 ··· cavity of mold, 30b ··· projection of cast-molded article, 30c ··· outer top surface of cast-molded article, 30d ··· fin, 33e ··· first opening of tray, 33f ··· second opening of tray, 72, 76, 85, 95 ··· XZ heat transfer member, 73, 77, 86, 96 ··· XY heat transfer member, 87, 97 ··· YZ heat transfer member, 81, 91 ··· base portion, 102 ··· heat source, 82, 92 ··· fin, 117s, 117t, 118s, 118t ··· groove

## Claims

1. A composite heat transfer member comprising:
a carbon plate; and
a metal cast-molded article covering a surface of the plate.

2. The composite heat transfer member according to claim 1,
wherein at least one through hole is provided in the plate, and
a portion of the cast-molded article fills up the through holes.

3. The composite heat transfer member according to claim 1, further comprising:
a metal tray accommodating the plate,
wherein the cast-molded article covers a top surface of the plate and outer lateral surfaces of the tray.

4. The composite heat transfer member according to claim 3,
wherein the cast-molded article also covers a bottom surface of the plate.

5. The composite heat transfer member according to claim 3,
wherein at least one through hole is provided in the plate,
a bottom of the tray is provided with openings that communicate with the through holes of the plate, and
a portion of the cast-molded article fills up the through holes and the openings.

6. The composite heat transfer member according to claim 5,
wherein the openings are larger than the through holes, and
the portion of the cast-molded article covers the surfaces of the plate that are exposed through the openings.

7. The composite heat transfer member according to claim 3,
wherein a depression is provided on the outer lateral surfaces, and
the cast-molded article has a projection that is fitted with the depression.

8. The composite heat transfer member according to claim 3,
wherein the metal of the tray is the same as the metal of the cast-molded article.

9. The composite heat transfer member according to claim 1,
wherein fins are provided on the cast-molded article.

10. The composite heat transfer member according to claim 1,
wherein the metal of the cast-molded article is an aluminum alloy or a magnesium alloy.

11. The composite heat transfer member according to claim 1,
wherein the plate is a laminate of graphenes.

12. The composite heat transfer member according to claim 11,
wherein the laminate has the graphenes laminated in a direction perpendicular to a thickness direction of the plate.

13. The composite heat transfer member according to claim 1,
wherein the plate has a first laminate which is constituted with graphenes laminated in a first direction perpendicular to a thickness direction of the plate and a second laminate which is constituted with graphenes laminated in a second direction parallel to the thickness direction of the plate, and
the first laminate and the second laminate contact each other in a third direction perpendicular to the first direction and the second direction.

14. The composite heat transfer member according to claim 3,
wherein the plate has a first laminate constituted with graphenes laminated in a first direction perpendicular to a thickness direction of the plate and a second laminate constituted with graphenes laminated in a second direction parallel to the thickness direction of the plate,
the tray has a first groove which accommodates the first laminate and a second groove which is connected to the first groove and accommodates the second laminate, and
the first laminate and the second laminate contact each other in a third direction perpendicular to the first direction and the second direction.

15. The composite heat transfer member according to claim 13, further comprising:
a third laminate constituted with graphenes laminated in the third direction,
wherein the cast-molded article covers surfaces of the third laminate, and
the third laminate contacts the first laminate and erects on the first laminate in the second direction.

16. The composite heat transfer member according to claim 13, comprising:
the third laminate constituted with graphenes laminated in the third direction,
wherein the cast-molded article covers the surfaces of the third laminate, and
the third laminate erects on the first laminate in the second direction in a state where a portion of the cast-molded article is interposed between the third laminate and the first laminate.

17. The composite heat transfer member according to claim 1,
wherein the plate has a first laminate constituted with graphenes laminated in a first direction perpendicular to a thickness direction of the plate, and
in the first direction, a dimension of the first laminate is identical to a dimension of a heat source on which the composite heat transfer member will be mounted.

18. A method for producing a composite heat transfer member, comprising:
a step of disposing a carbon plate in a cavity of a casting mold; and
a step of covering a surface of the plate with a metal cast-molded article by supplying a molten metal into the cavity so as to form the metal cast-molded article.

19. The method for producing a composite heat transfer member according to claim 18,
wherein in the step of disposing the plate in the cavity, the plate is disposed in the cavity in a state where the plate is accommodated in a metal tray, and
in the step of covering the surface of the plate by the cast-molded article, a top surface of the plate and outer lateral surfaces of the tray are covered with the cast-molded article.

20. The method for producing a composite heat transfer member according to claim 18,
wherein the plate has a first laminate which is constituted with graphenes laminated in a first direction perpendicular to a thickness direction of the plate and a second laminate which is constituted with graphenes laminated in a second direction parallel to the thickness direction of the plate, and
the first laminate and the second laminate contact each other in a third direction perpendicular to the first direction and the second direction.

21. The method for producing a composite heat transfer member according to claim 19,
wherein the tray has a first groove and a second groove connected to the first groove,
the plate has a first laminate which is constituted with graphenes laminated in a first direction perpendicular to a thickness direction of the plate and a second laminate constituted with graphenes laminated in a second direction parallel to the thickness direction of the plate, and
the first laminate is accommodated in the first groove and the second laminate is accommodated in the second groove such that the first laminate and the second laminate contact each other in a third direction perpendicular to the first direction and the second direction.
